# EUROPEAN PATENT SPECIFICATION

(11) **EP 4 483 410 B1**
(45) Date of publication and mention of the grant of the patent: **28.05.2025**
(21) Application number: 23722121.3
(22) Date of filing: 07.04.2023
(51) Int. Cl.: H01L 25/065, H01L 21/60, H01L 21/98, H01L 23/482, H01L 23/66, H01L 27/088, H03K 17/10

(54) **3-DIMENSIONAL INTEGRATED CIRCUIT STRUCTURES AND CIRCUITS**
DREIDIMENSIONALE INTEGRIERTE SCHALTUNGSSTRUKTUREN UND SCHALTUNGEN
STRUCTURES DE CIRCUIT INTÉGRÉ TRIDIMENSIONNEL ET CIRCUITS

(30) Priority: 13.04.2022 US 202263330610 P
(43) Date of publication of application: 01.01.2025
(60) Divisional application: 25165122.0
(73) Proprietor: MURATA MANUFACTURING CO., LTD., Nagaokakyo-shi, Kyoto 617-8555 (JP)
(72) Inventor: RAY, Shishir, San Diego, California 92121 (US); GOKTEPELI, Sinan, San Diego, California 92121 (US); SHAPIRO, Eric S., San Diego, California 92121 (US); WILLARD, Simon Edward, San Diego, California 92121 (US); KOUASSI, Kouassi Sebastien, San Diego, California 92121 (US); SHIBATA, Kazuhiko, San Diego, California 92121 (US); ERB, Jean-Luc, San Diego, California 92121 (US); DYKSTRA, Jeffrey A., San Diego, California 92121 (US)
(74) Representative: Riccardi, Elisa
(86) International application number: PCT/US2023/017960
(87) International publication number: WO 2023/200691

(56) References cited:
- US-A1- 2015 137 335
- US-A1- 2021 013 119
- US-A1- 2021 074 730

## Description

### CROSS-REFERENCE TO RELATED APPLICATIONS

The present application claims priority to U.S Provisional Patent Application No. 63/330,610, filed on April 13, 2022, for "3-DIMENSIONAL INTEGRATED CIRCUIT STRUCTURES AND CIRCUITS".

### FIELD

The present invention relates to three-dimensional integrated circuit structures and circuits.

### BACKGROUND

The electronics industry continues to strive for ever-increasing electronic functionality and performance in a wide variety of products, including (by way of example only) personal electronics (*e*.*g*., "smart" watches and fitness wearables), personal computers, tablet computers, wireless network components, televisions, cable system "set top" boxes, radar systems, and cellular telephones. Increased functionality and/or performance commonly translates to more transistors and other electronic components on an integrated circuit (IC) die. While the number of transistors per unit area of an IC die has increased over time as IC manufacturing process nodes have shrunk device dimensions, the two-dimensional (2-D) planar "footprint" of some IC dies has not decreased at the same rate, primarily owing to the use of more (albeit smaller) transistors to implement increased functionality and/or performance. The 2-D footprint of an IC die is one constraint on reducing the size of modules and circuit boards within products.

In order to shrink the 2-D footprint of an IC die, a number of three-dimensional (3-D) technologies have been developed that have focused on stacking and bonding aligned IC dies on different wafers (also known as wafer-to-wafer bonding), stacking and bonding individual IC dies on non-singulated IC dies on a wafer (also known as die-to-wafer bonding), and stacking and bonding an individual IC die on another IC die (also known as die-to-die bonding). One such technology may be referred to as "hybrid bonding interconnect" (HBI), in which the circuitry of a 2-D IC is divided and fabricated on different wafers or dies and then vertically stacked in a 3-D structure, with, for example, about half of the circuitry formed on a first or "bottom" wafer/die, and about half of the circuitry formed on a second or "top" wafer or die that is then bonded to the bottom wafer/die. Bonding of the two wafers/dies generally uses both dielectric materials (*e*.*g*., silicon dioxide, SiCN, SiCOH, and/or analogous alloys) and conductive interconnect materials (*e*.*g*., copper, aluminum, and/or their alloys). In general, a high density of interconnects between the top and bottom wafers/dies is desirable to achieve good communications between them. The interconnect pitch can be between about 0.2 to 10µm, and preferably in approximately the 2-5 µm range. HBI technology has a demonstrated high interconnect density, is a planar technology that does not require underfill or carrier wafer integration, and enables formation of interconnects between two IC wafers/dies during the bonding stage of processing at relatively low temperatures (*e*.*g*., < 400 °C).

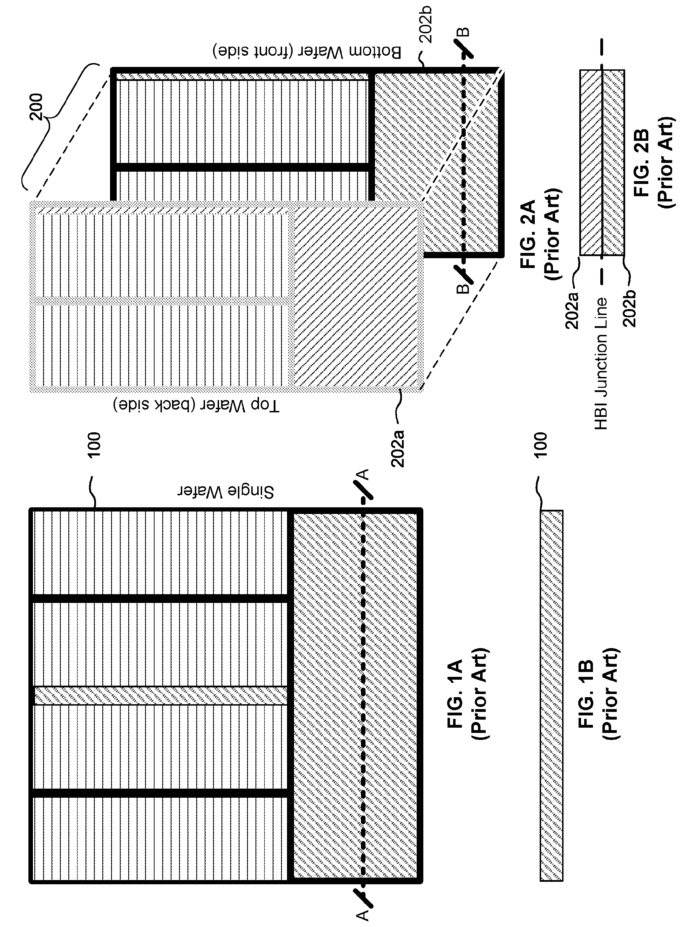

As one example of the planar space savings provided by HBI technology, FIG. 1A is a top plan view of a prior art IC die 100 formed from a single wafer, and FIG. 1B is a cross-sectional view of the prior art IC die 100 of FIG. 1A, taken along line A-A of FIG. 1A. In contrast, FIG. 2A is a top plan view of the same circuitry formed on a stacked IC die 200 by prior art HBI technology, and FIG. 2B is a cross-sectional view of the prior art stacked IC die 200 of FIG. 2A, taken along line B-B of FIG. 2A.

FIG. 2A is shown in expanded form to highlight that the stacked IC die 200 comprises circuitry from a top wafer 202a (shown from the back side) overlaid onto circuitry from a bottom wafer 202b (shown from the front side). As inspection of FIGS. 2A and 2B shows, the planar area or "footprint" of the stacked IC die 200 is significantly less (about one-half the size) than the planar area of the IC die 100, while the stacked height of the stacked IC die 200 is greater (about twice the height in some cases) of the height of the IC die 100.

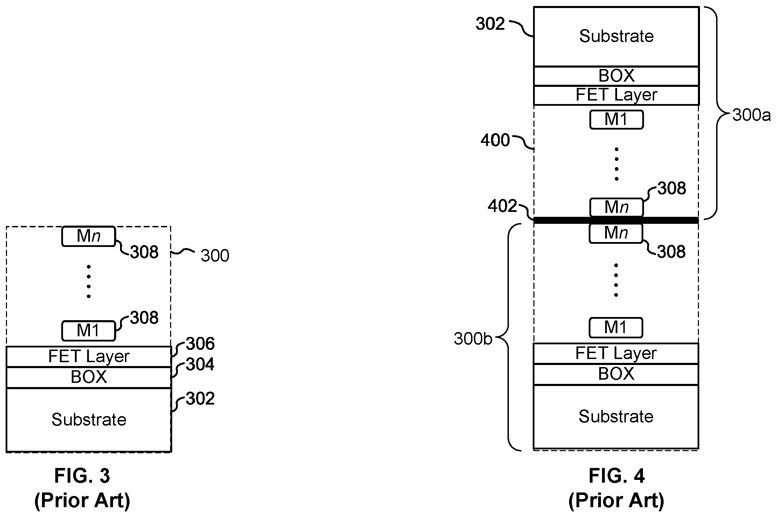

HBI technology allows for a number of different stacking structures. By way of background, FIG. 3 is a stylized cross-sectional view through a 2-D field effect transistor (FET) 300 formed using a prior art silicon-on-insulator (SOI) fabrication process. Starting with a substrate 302, such as silicon, an insulating buried oxide (BOX) layer 304 is formed, on which an active "FET" layer is formed *(e.g.,* doped silicon with mask-formed channel, gate, source, drain, and isolation regions), in known fashion. The IC fabrication process up to this point is generally considered the front-end-of-line (FEOL) where individual devices (transistors, capacitors, resistors, inductors *etc.)* are patterned in or on the FET layer. The FEOL generally covers everything up to (but not including) the deposition of metal interconnect layers.

After the last FEOL step, a wafer generally consists of isolated transistors without any interconnecting conductors. The back end of line (BEOL) is the second portion of IC fabrication where the individual devices (transistors, capacitors, resistors, inductors, *etc.)* are interconnected with conductors formed as part of or between one or more metal interconnect layers. BEOL includes fabrication of electrical contacts (pads), vias, insulating layers (dielectrics), metal levels, and bonding sites for chip-to-package connections. For example, in FIG. 3, metal interconnect layers M1... Mn 308 are shown, where n is greater than or equal to 1.

FIG. 4 shows an example of a 3-D stacking structure that may be fabricated using HBI technology based on the 2-D FET 300 of FIG. 3 (note that not all SOI FET layers are labeled with reference numbers to avoid clutter). In particular, FIG. 4 is a stylized cross-sectional view through a configuration 400 of two SOI FETs bonded "top-to-top" using an HBI technology fabrication process. Thus, for example, a first instance 300a of the FET 300 is inverted and bonded to a second instance 300b of the FET 300 from FIG. 3 through an HBI 402.

Although shown as a line in FIG. 4, the HBI 402 typically would be implemented as vias from an outer surface of the top wafer or die to an underlying metal interconnect layer 308. It should be appreciated that different 3-D stacking structures may be fabricated using HBI technology.

While HBI technology is known and has been applied to some degree in the microprocessor, electronic memory, and digital logic fields, usage of HBI technology for analog circuitry, and particularly for radio frequency (RF) circuitry, has not been as widespread. RF circuitry poses a number of design challenges in 2-D ICs that can be exacerbated in 3-D designs, keeping in mind that each RF FET imposes some resistance, R_{ON}, when set to a conducting (ON) state, some capacitance, C_{OFF}, when set to a non-conducting (OFF) state, has a gate capacitance to be charged or discharged to change states, and may be operating at frequencies well in excess of 100 MHz. Thus, it is important, and often critical, to design for parasitic resistances, capacitances, and/or inductances that can adversely affect power efficiency, linearity, noise factor (NF), and impedance matching, *etc.,* and/or cause generation of unwanted harmonic frequencies.

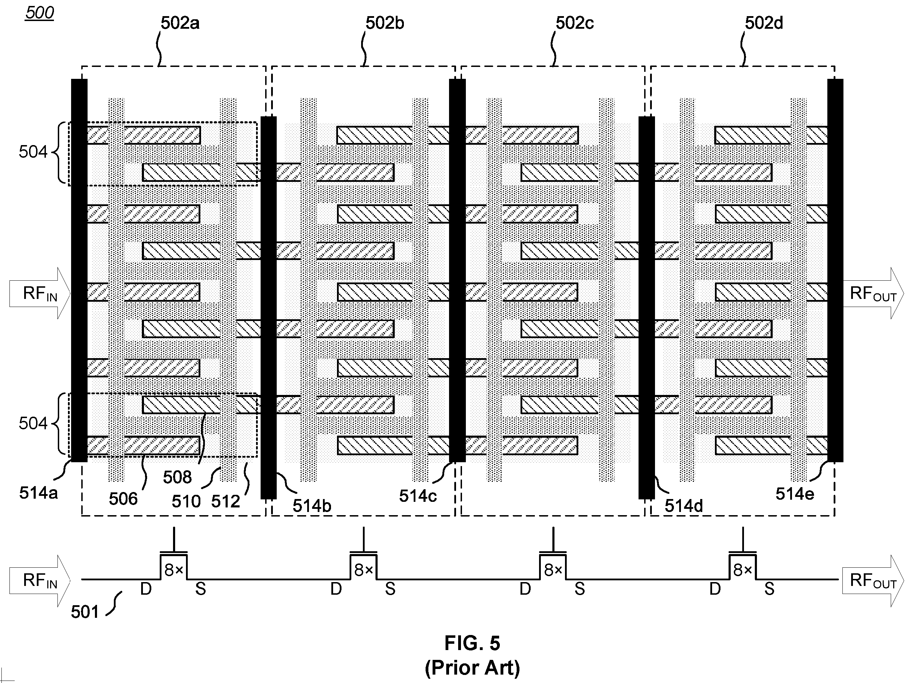

As one example of RF circuitry, FIG. 5 is a stylized top view of the IC layout of a prior art 2-D FET switch array 500, below which is a symbolic view 501 of the same circuit. The illustrated 2-D FET switch array 500 is a small-scale version of a type that may be used, for example, in an RF switch circuit. Such RF switch circuits may be used, for example, between an antenna and a low-noise amplifier (LNA) or a power amplifier, or elsewhere within an RF transmitter, receiver, or transceiver where RF switching may be needed.

Shown in FIG. 5 are four series-coupled FET cells 502a-502d (generically, "502x") each comprising, in this example, eight parallel-connected FETs 504 (not all FETs are labeled to avoid clutter, and the symbolic view 501 shows "8×" within each FET symbol to indicate the number of parallel-connected FETs in this example). Each FET includes a drain region 506, a source region 508, and a gate region 510 that controls all FETs 504 within a FET cell 502x, all formed over a suitable field 512 defined on a substrate, in known fashion. Each adjacent pair of drain region 506 and source region 508 "fingers" forms one FET controlled by the corresponding portion of the gate region 510. A set of buses 514a-514b connect multiple drains or multiple sources. Thus, for example, all of the drain regions 506 within FET cell 502a are connected on a first side of the cell (left side in the figure) by a bus 514a, and all of the source regions 508 within FET cell 502a are connected on a second side of the cell (right side in the figure) by a bus 514b. Adjacent FET cells 502x may share a bus, which thus provides a serial connection between those FET cells. For example, bus 514b connects the source regions 508 of FET cell 502a to the drain regions 506 of adjacent FET cell 502b.

The parallel arrangement of individual FETs 504 within the FET cells 502x provides the ability to convey current to meet a specification. In some applications, the number of parallel-connected FETs 504 within a cell 502x may be many hundreds of FETS. The serial arrangement of FET cells 502x provides the ability to withstand a specified design voltage. In some applications, the number of serially-connected FET cells 502x may be many tens of FET cells. Further, multiple switch arrays 500 may be implemented on a single die, such as for series and shunt switch circuits for an antenna tuning switch IC. Altogether, the number of FETs in one or more switch arrays 500 on an RF IC may exceed 100,000 drain-source finger pairs, many of which may be conveying frequencies well in excess of 100 MHz. In light of the parasitic resistances, capacitances, and/or inductances that can arise from laying out such a quantity of FETs, it should be appreciated that simply applying HBI technology to bond two ICs embodying such analog RF circuitry is not a simple design exercise.

Moreover, document US 2015/137335 A1 discloses:
An integrated FET switch circuit including: a first wafer/die including a first set of groups of FET cells laid out in a sequence, each group of FET cells including a first side drain bus and a second side source bus and including a second set of groups of FET cells laid out in a sequence, each group of FET cells including a first side drain bus and a second side source bus; wherein the first side drain bus of each group in the first wafer/die is electrically connected to the second side source bus of a first corresponding group; and wherein the second side source bus of each group in the first wafer/die is electrically connected to the first side drain bus of a second corresponding group.

Accordingly, there is a need for 3-D integrated circuit structures and circuits that enable high performance FET switch arrays while consuming less planar area than conventional 2-D IC dies.

### SUMMARY

The present invention encompasses 3-D integrated circuit structures and circuits that enable high performance FET switch arrays while consuming less planar area than conventional 2-D IC dies.

In one embodiment according to the claimed invention, an integrated FET switch circuit includes a first wafer/die including a first set of groups of FET cells laid out in a sequence, each group of FET cells including a first side drain bus and a second side source bus; and a second wafer/die joined to the first wafer/die through hybrid bonding interconnects and including a second set of groups of FET cells laid out in a sequence, each group of FET cells including a first side drain bus and a second side source bus; wherein the first side drain bus of each group in the first wafer/die is electrically connected through the hybrid bonding interconnects to the second side source bus of a first corresponding group in the second wafer/die; and wherein the second side source bus of each group in the first wafer/die is electrically connected through the hybrid bonding interconnects to the first side drain bus of a second corresponding group in the second wafer/die.

In another embodiment, which does not form part of the claimed invention but is useful for understanding the invention, an integrated FET switch circuit includes a first wafer/die including a first set of groups of FET cells laid out in a sequence, each group of FET cells including a first side drain bus and a second side source bus, the groups of FET cells being coupled in series; and a second wafer/die joined to the first wafer/die through hybrid bonding interconnects and including a second set of groups of FET cells laid out in a sequence, each group of FET cells including a first side drain bus and a second side source bus, the groups of FET cells being coupled in series; wherein the first side drain bus of each group in the first wafer/die is electrically connected through the hybrid bonding interconnects to the first side drain bus of a corresponding group in the second wafer/die; and wherein the second side source bus of each group in the first wafer/die is electrically connected through the hybrid bonding interconnects to the second side source bus of the corresponding group in the second wafer/die.

In yet another embodiment, which does not form part of the claimed invention but is useful for understanding the invention, an integrated FET switch circuit includes a first wafer/die including a first set of FET cells laid out in a sequence, the FET cells being coupled in series, each set of FET cells including a first side drain bus and a second side source bus; and a second wafer/die joined to the first wafer/die through hybrid bonding interconnects and including a second set of FET cells laid out in a sequence, the FET cells being coupled in series, each set of FET cells including a first side drain bus and a second side source bus; wherein the first side drain bus of the set of FET cells in the first wafer/die is electrically connected through the hybrid bonding interconnects to the first side drain bus of the set of FET cells in the second wafer/die; and wherein the second side source bus of the set of FET cells in the first wafer/die is electrically connected through the hybrid bonding interconnects to the second side source bus of the set of FET cells in the second wafer/die.

The details of one or more embodiments of the invention are set forth in the accompanying drawings and the description below. Other features, objects, and advantages of the invention will be apparent from the description and drawings, and from the claims.

### DESCRIPTION OF THE DRAWINGS

FIG. 1A is a top plan view of a prior art IC die formed on a single wafer.
FIG. 1B is a cross-sectional view of the prior art IC die of FIG. 1A, taken along line A-A of FIG. 1A.
FIG. 2A is a top plan view of the same circuitry formed on a stacked IC die by prior art HBI technology.
FIG. 2B is a cross-sectional view of the prior art stacked IC die of FIG. 2A, taken along line B-B of FIG. 2A.
FIG. 3 is a stylized cross-sectional view through a 2-D field effect transistor (FET) formed using a prior art silicon-on-insulator (SOI) fabrication process.
FIG. 4 is a stylized cross-sectional view through a configuration of two SOI FETs bonded "top-to-top" using an HBI technology fabrication process.
FIG. 5 is a stylized top view of the IC layout of a prior art 2-D FET switch array, below which is a symbolic view of the same circuit.
FIG. 6A is a schematic diagram of a first embodiment, which is according to the claimed invention, of a FET switch circuit configured to be implemented in a 3-D integrated circuit structure using HBI or analogous technology.
FIG. 6B is a stylized IC layout of the FET switch circuit of FIG. 6A, showing the pre-bonding positions of HBI plugs on top and bottom wafers/dies.
FIG. 6C is a stylized cross-sectional view along line C-C of the IC of FIG. 6B, showing the post-bonding positions of HBI plugs on top and bottom wafers/dies through an HBI.
FIG. 7 is a stylized top view of the IC layout of the prior art 2-D FET cell from FIG. 5.
FIG. 8 is a stylized top view of the IC layout of a FET cell from FIG. 6B, shown with greater detail for the associated FETs.
FIG. 9A is a schematic diagram of a second embodiment, which is according to the claimed invention, of a FET switch circuit configured to be implemented in a 3-D integrated circuit structure using HBI or analogous technology.
FIG. 9B is a stylized IC layout of the FET switch circuit of FIG. 9A, showing the pre-bonding positions of HBI plugs on top and bottom wafers/dies.
FIG. 10 is a stylized top view of the IC layout of a FET cell from FIG. 9B, showing greater detail for the associated FET pairs.
FIG. 11A is a schematic diagram of a third embodiment, which does not form part of the claimed invention but is useful for understanding the invention, of a FET switch circuit configured to be implemented in a 3-D integrated circuit structure using HBI or analogous technology.
FIG. 11B is a stylized IC layout of the FET switch circuit of FIG. 11A, showing the pre-bonding positions of HBI plugs on top and bottom wafers/dies.
FIG. 12 is schematic diagram of a fourth embodiment, which does not form part of the claimed invention but is useful for understanding the invention, of a FET switch circuit configured to be implemented in a 3-D integrated circuit structure using HBI or analogous technology.
FIG. 13A is a stylized cross-sectional view through a configuration of two SOI FETs bonded "top-to-top" using an HBI technology fabrication process.
FIG. 13B is a stylized cross-sectional detailed view of the FET layer and CAS gate structure of FIG. 13A, omitting the other structures shown in FIG. 13A for clarity.
FIG. 13C is symbolic representation of a CAS-gated FET.
FIG. 14 is a top plan view of a substrate that may be, for example, a printed circuit board or chip module substrate (*e*.*g*., a thin-film tile).
FIG. 15 illustrates an exemplary prior art wireless communication environment comprising different wireless communication systems, and which may include one or more mobile wireless devices.
FIG. 16 is a block diagram of a transceiver that might be used in a wireless device, such as a cellular telephone, and which may beneficially incorporate an embodiment of the present invention.
FIG. 17 is a process flow chart showing a first method, according to the claimed invention, of creating an integrated FET switch circuit.
FIG. 18 is a process flow chart showing a second method, which does not form part of the claimed invention but is useful for understanding the invention, of creating an integrated FET switch circuit.
FIG. 19 is a process flow chart showing a third method, which does not form part of the claimed invention but is useful for understanding the invention, of creating an integrated FET switch circuit.

Like reference numbers and designations in the various drawings indicate like elements.

### DETAILED DESCRIPTION

The present invention encompasses 3-D integrated circuit structures and circuits that enable high performance FET switch arrays while consuming less planar area than conventional 2-D IC dies.

### First Embodiment, which is according to the claimed invention

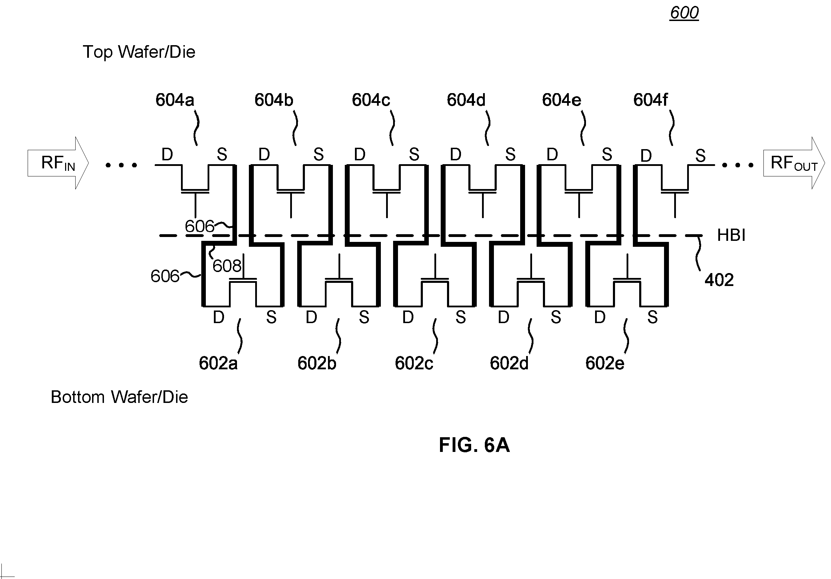

FIG. 6A is a schematic diagram of a first embodiment of a FET switch circuit 600 configured to be implemented in a 3-D integrated circuit structure using HBI or analogous technology. In this example of the first embodiment, a bottom wafer or die ("wafer/die" hereafter) includes a first set of individual FET cells 602a-602e laid out in physical sequence, and the top wafer/die includes a second set of individual FETs 604a-604f laid out in physical sequence. Thus, the first and second sets of FET cells each comprise one or more groups of single FET cells (*i.e.,* groups of one). Conductive vias 606 and/or traces 608 are formed in known fashion in both the top and bottom wafers/dies to as to electrically connect, after application of an HBI bonding process, the source of a top-wafer/die FET (*e.g.,* FET 604a) to the drain of an associated bottom-wafer/die FET (*e.g.,* FET 602a), and the source of that bottom-wafer/die FET (*e.g.,* FET 602a) to the drain of an associated next top-wafer/die FET (*e.g.,* FET 604b). An RF_{IN} signal applied to the drain of FET 604a may be selectively conducted as an output signal through the source of FET 604f, or blocked, based on applied gate control signals for the sets of FET cells 602a-602e, 604a-604f. In effect, the first set of FET cells 602a-602e is essentially interleaved 1:1 with the second set of FET cells 604a-604f.

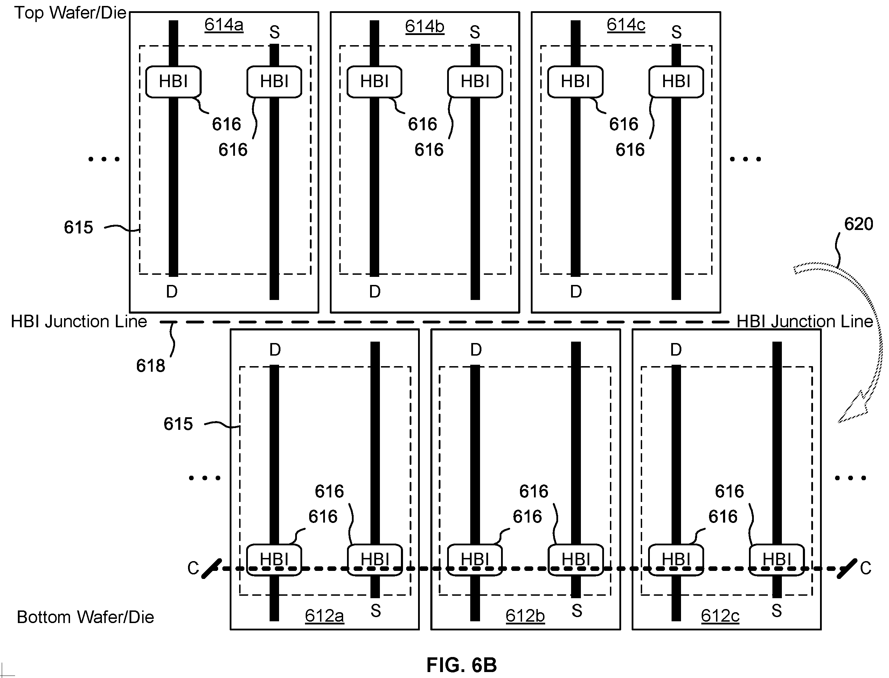

FIG. 6B is a stylized IC layout of the FET switch circuit 600 of FIG. 6A, showing the pre-bonding positions of conductive HBI "plugs" on top and bottom wafers/dies. A bottom wafer/die is shown as including a first set of 3 FET cells 612a-612c, and a top wafer/die is shown as including a second set of 3 FET cells 614a-614c. The FET cells 612a-612c, 614a-614c are depicted in simplified form, but would be similar in general to the FET cells 502a-502d shown in FIG. 5; in simplified FIG. 6B, the source and drain region "fingers" and gate regions of FIG. 5 are depicted as a simple dashed square 615. Of note, the FET cells 612a-612c, 614a-614c may thus include many hundreds of parallel-connected FETs per cell. In some applications, the number of cells in the first and second sets of cells may be many tens of FET cells.

A distinct departure from the cell layout shown in FIG. 5 is that each FET cell 612a-612c, 614a-614c in a wafer/die includes one or more HBI plugs configured to electrically connect, after HBI bonding, with an HBI plug in the other wafer/die. Thus, for example, FET cell 612a in the bottom wafer/die includes an HBI plug 616 formed in electrical contact with the drain bus D of FET cell 612a and configured to be bonded to a corresponding HBI plug 616 formed in electrical contact with the source bus S of FET cell 614a. As another example, FET cell 612a in the bottom wafer/die includes an HBI plug 616 formed in electrical contact with the source bus S of FET cell 612a and configured to be bonded to a corresponding HBI plug 616 formed in electrical contact with the drain bus D of FET cell 614b. Note that while the HBI plugs 616 are shown formed directly over a drain bus D or source bus S, the HBI plugs 616 may be positioned elsewhere by appropriate use of conductive vias 606 and/or traces 608 (see, *e.g.,* FIG. 6A). Further, to be clear, although FIG. 6B shows only one HBI plug per drain bus or source bus, multiple HBI plugs may be used on corresponding drain or source buses to reduce resistance. Since the groups in the sets of FET cells each comprise only one FET cell in this embodiment, the drain bus of each FET cell can be considered a "first side" drain bus for a group, and the source bus of each FET cell can be considered a "second side" source bus for a group.

When the top wafer/die is flipped over on top of the bottom wafer/die during the HBI bonding process (*e.g.,* the top wafer/die is figuratively "pivoted" around an HBI Junction Line 618 as suggested by the arrow 620), the HBI plugs 616 in associated FET cells 612a-612c, 614a-614c are aligned and can bond, completing the circuit structure shown schematically in FIG. 6A.

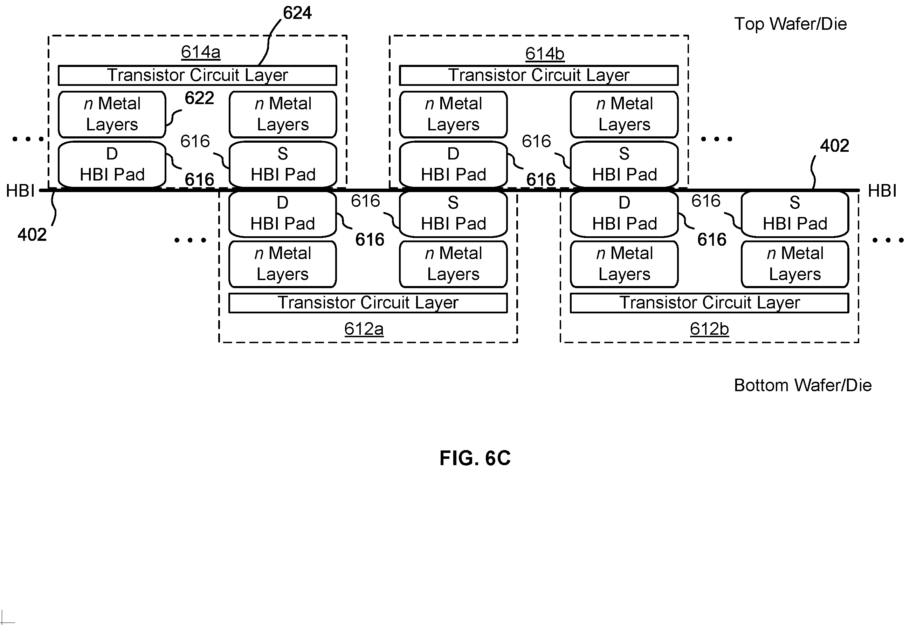

FIG. 6C is a stylized cross-sectional view along line C-C of the IC of FIG. 6B, showing the post-bonding positions of HBI plugs 616 on top and bottom wafers/dies through an HBI 402 (due to space constraints, only two FET cells 612a-612b, 614a-614b are shown per wafer). The cross-sectional structure of the FET cells 612a-612b, 614a-614b has been simplified to show the various metal interconnect layers as "n Metal Layers" 622 and the FET structure itself (drain, channel, gate, source, *etc.*) as a "Transistor Circuit Layer" 624.

It should be appreciated that some dimensions in FIGS. 6A-6C may be greatly exaggerated vertically and/or horizontally for clarity or emphasis. For example, the horizontal spacing (across the figure) of the FET cells 612a-612b, 614a-614b in the top and bottom wafers/dies shown in FIG. 6B is exaggerated. Actual IC embodiments may achieve essentially about a 100% overlap of top-wafer/die FET cells with respect to bottom-wafer/die FET cells, since the conductive vias 606 and/or traces 608 (see FIG. 6A) provide flexibility in routing connections between top-wafer/die HBI plugs to bottom-wafer/die HBI plugs. For example, referring to FIG. 6B, using conductive vias 606 and/or traces 608 between respective HBI plugs, FET cell 614a may be positioned with respect to FET cell 612a such that the two FET cells overlap about 100% from left-side to right-side with respect to the figure. Thus, an advantage of the interleaved architecture shown in FIGS. 6A-6C is that the width (across the figure) of what would be a long sequence of serially-connected FETs in a 2-D layout is substantially reduced (by as much as half) when implemented in a 3-D layout in which a FET stack is divided into top and bottom wafers/dies bonded in an HBI stack. When the FET cells are in the ON state, an applied RF signal "ping pongs" back and forth among associated but alternating FETs in the top and bottom wafers/dies (*e*.*g*., from 604a to 602a, from 602a to 604b, ... from 602e to 604f). Accordingly, the resulting 3-D IC would be substantially smaller in planar area than the corresponding 2-D implementation.

Another advantage of the interleaved architecture shown in FIGS. 6A-6C is reduced parasitic ON-state resistance R_{ON} by going up and down between FETs on different wafers/dies. Currently, the pitch of HBI plugs is typically 2.0-2.5µm, and pitch of HBI plugs is expected to be smaller in the future. Such short routing paths result in smaller parasitic resistance, a particular benefit for RF circuits.

Yet another advantage of the interleaved architecture shown in FIGS. 6A-6C is that the top-wafer/die to bottom-wafer/die offset (vertically with respect to the figure) between connected FETs may help reduce unwanted harmonics and nonlinearity, since the vertical distance between "stacked" FETs from top-wafer/die to bottom-wafer/die is generally short and such vertical connections reduce the amount of horizontal (with respect to the figure) conductive traces within each individual wafer/die that can result in higher parasitical capacitance than an HBI stack.

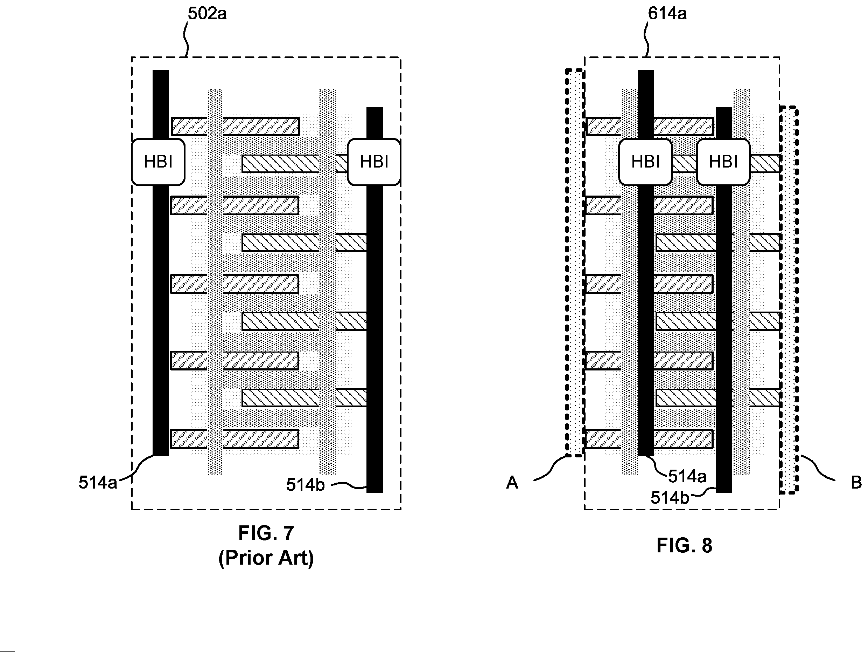

The embodiment shown in FIGS. 6A-6C, which is according to the claimed invention, may be further reduced in planar area by moving the location of the source and drain buses inward from the edges of each FET cell. For example, FIG. 7 is a stylized top view of the IC layout of the prior art 2-D FET cell 502a from FIG. 5. Of note, the drain and source buses 514a, 514b for the illustrated 2-D FET cell 502a (as well as for the other cells 502b-502d shown in FIG. 5) must generally be positioned on the "outer" edges of the FET cell, since at least one and most often both of the drain and source buses 514a, 514b are shared with an adjacent FET cell in the same wafer/die. For example, as shown in FIG. 5, bus 514b connects the source regions of FET cell 502a to the drain regions of the adjacent FET cell 502b. Any other position would mean that the drain and source buses 514a, 514b cannot be shared with an adjacent FET cell, thus necessitating additional conductive traces and vias in the metal interconnect layers just to couple one FET cell to the next FET cell, thereby increasing ON state resistance and parasitic capacitance.

Although conventional FET cells with "outer" edge source and drain buses may be used in the embodiments shown in FIGS. 6A-6C, improved FET cells with "inside" source and drain buses spaced inwardly from the FET cell edges provides even greater planar area savings. For example, FIG. 8 is a stylized top view of the IC layout of a FET cell 614a from FIG. 6B, shown with greater detail for the associated FETs. The drain and source buses 514a, 514b for the example FET cell 614a (as well as for the other FET cells 614a-614c, 612a-612c shown in FIG. 6B) may be spaced away from the "outer" edges of the cell (indicated by dashed regions A and B) to, for example, the illustrated "inside" positions. The effective width (across the figure) of the example FET cell 614a is thus decreased compared to the prior art 2-D FET cell 502a of FIG. 7. The conductive vias 606 and/or traces 608 (see FIG. 6A) thus provide flexibility in routing connections between top-wafer/die HBI plugs to bottom-wafer/die HBI plugs. Since the drain and source buses 514a, 514b of the FET cell 614a need not couple to an adjacent FET cell in the same wafer/die, but instead may couple to associated FET cells in the HBI-connected wafer/die, "inside" placement of the drain and source buses 514a, 514b is a new design option that reduces the planar area of the FET cell 614a compared to the conventional FET cell shown in FIG. 7.

Another advantage of "inside" placement of the drain and source buses 514a, 514b is reduced R_{ON} resistance, since the buses can be placed anywhere above the drain region 506 and source region 508 "fingers" and connected to those fingers via metal interconnect layers. Accordingly, the distance to both ends of such fingers is shorter - and hence lower in resistance - compared to bus placement at an edge of those fingers.

### Second Embodiment, which is according to the claimed invention

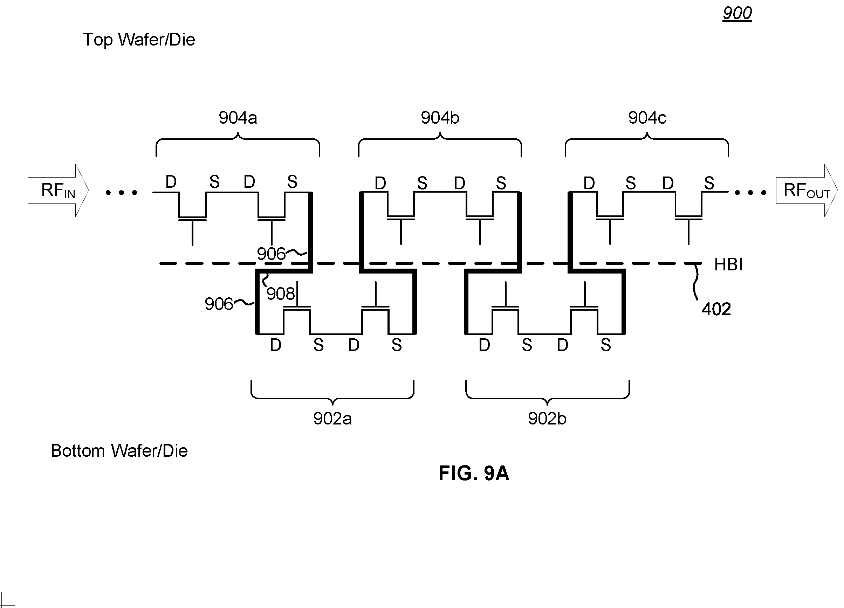

FIG. 9A is a schematic diagram of a second embodiment of a FET switch circuit 900 configured to be implemented in a 3-D integrated circuit structure using HBI or analogous technology. In this example of the second embodiment, a bottom wafer/die includes a first set of FET cell pairs 902a-902b laid out in physical sequence, and the top wafer/die includes a second set of FET cell pairs 904a-904c laid out in physical sequence. Thus, the first and second sets of FET cells each comprise one or more FET cells in groups of two (*i*.*e*., pairs). Conductive vias 906 and/or traces 908 are formed in known fashion in both the top and bottom wafers/dies to as to electrically connect, after application of an HBI bonding process, the source of a right-most FET of a top-wafer/die FET pair (*e.g.,* the right-most FET of top-wafer/die FET pair 904a) to the drain of a left-most FET of a bottom-wafer/die FET pair (*e.g.,* the left-most FET of bottom-wafer/die FET pair 902a). Similar conductive vias and/or traces (not labeled) are formed in known fashion in both the top and bottom wafers/dies to as to electrically connect, after application of an HBI bonding process, the source of a right-most FET of a bottom-wafer/die FET pair (*e.g.,* the right-most FET of bottom-wafer/die FET pair 902a) to the drain of a left-most FET of a top-wafer/die FET pair (*e.g.,* the left-most FET of top-wafer/die FET pair 904b). An RF_{IN} signal applied to the drain of FET pair 904a may be selectively conducted as an output signal through the source of FET pair 904c, or blocked, based on applied gate control signals for the sets of FET cell pairs 902a-902b, 904a-904c. In effect, the first set of FET cell pairs 902a-902b is essentially interleaved 2:2 with the second set of FET cell pairs 904a-904c.

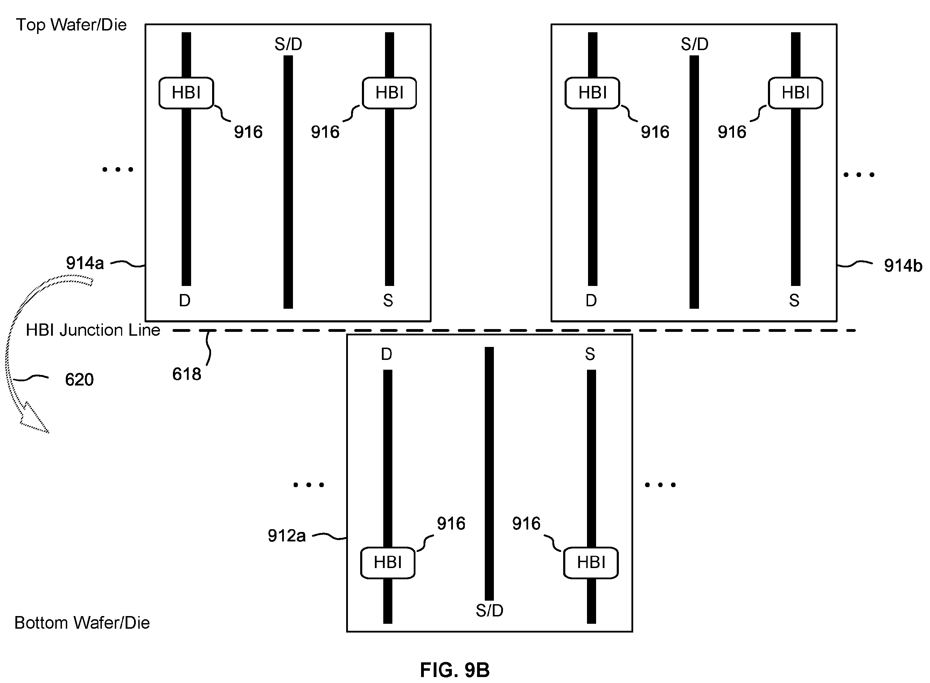

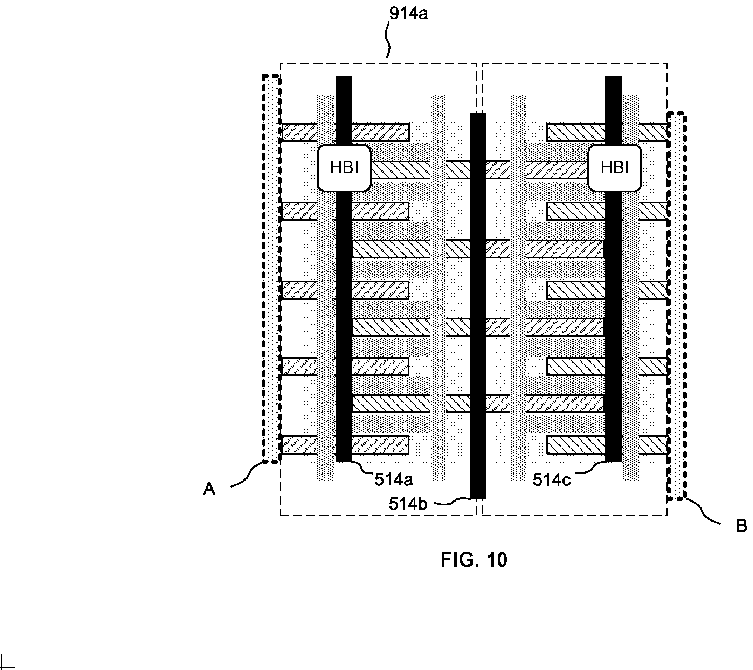

FIG. 9B is a stylized IC layout of the FET switch circuit 900 of FIG. 9A, showing the pre-bonding positions of HBI plugs on top and bottom wafers/dies. A bottom wafer/die is shown as including a first set of one pair of series-coupled FET cells 912a, and a top wafer/die is shown as including a second set of two pairs of series-coupled FET cells 614a-614b. The FET cell pairs 912a, 914a-914b are depicted in simplified form (see FIG. 10 for a more detailed version of such FET cell pairs) but may include many hundreds of parallel-connected FETs per cell pair, and in some applications, the number of FET cells in the first and second sets of cells may be many tens of FET cells.

Each FET cell pair 912a, 914a-914b in a wafer/die includes one or more HBI plugs configured to electrically connect, after HBI bonding, with an HBI plug in the other wafer/die. Thus, for example, FET cell pair 912a in the bottom wafer/die includes an HBI plug 916 formed in electrical contact with a first side (left-side in the figure) drain bus D of FET cell pair 912a and configured to be bonded to a corresponding HBI plug 916 formed in electrical contact with a second side (right-side in the figure) source bus S of FET cell pair 914a. As another example, FET cell pair 912a in the bottom wafer/die includes an HBI plug 916 formed in electrical contact with a second side (right-side in the figure) source bus S of FET cell pair 912a and configured to be bonded to a corresponding HBI plug 916 formed in electrical contact with the first side (left-side in the figure) drain bus D of FET cell pair 914b. Again, while the HBI plugs 916 are shown formed directly over a drain bus D or source bus S, the HBI plugs 916 may be positioned elsewhere by appropriate use of conductive vias 906 and/or traces 908 (see, *e.g.,* FIG. 9A). Further, to be clear, although FIG. 9B shows only one HBI plug per drain bus or source bus, multiple HBI plugs may be used on corresponding drain or source buses to reduce resistance. Since the groups in the sets of FET cells each comprise two FET cells in this embodiment, the left-most (relative to the figure) drain bus of each group of two FET cells can be considered a "first side" drain bus for the group, and the right-most (relative to the figure) source bus of each group of two FET cells can be considered a "second side" source bus for the group.

When the top wafer/die is flipped over on top of the bottom wafer/die during the HBI bonding process (*e.g.,* the top wafer/die is figuratively "pivoted" around an HBI Junction Line 618 as suggested by the arrow 620), the HBI plugs 916 in associated FET cell pairs 912a, 914a-914b are aligned and can bond, completing the circuit structure shown schematically in FIG. 9A.

An advantage of the interleaved architecture shown in FIGS. 9A-9B is that the width (across the figure) of what would be a long sequence of serially-connected FETs in a 2-D layout is substantially reduced when implemented in a 3-D layout in which a FET stack is divided into top and bottom wafers/dies bonded in an HBI stack. Accordingly, the resulting 3-D IC would be substantially smaller in planar area than the corresponding 2-D implementation. One difference from the first embodiment described above is that associating a pair of FET cells on the top wafer/die with a pair of FET cells on the bottom wafer/die can reduce the number of HBI plugs per wafer/die.

Yet another advantage of the interleaved architecture shown in FIGS. 9A-9B is that the top-wafer/die to bottom-wafer/die offset (vertically with respect to the figure) between connected FET cell pairs may help reduce unwanted harmonics and nonlinearity.

As should be apparent, additional interleaving ratios may be used (*e.g.,* 3:3 interleaving, 4:4 interleaving, *etc.*) by expanding the number of FET cells per group for the sets of cells associated with the top and bottom wafers/dies to include 3, 4, or more sequentially-connected FET cells before connecting the sets from wafer/die to wafer/die. Thus, most generally, the first and second sets of FET cells associated with the top and bottom wafers/dies each comprise one or more groups of FET cells, where each group includes *n* FET cells, where *n* ≥ 1, and where, when n > 1, the FET cells within a group are coupled in series. Note, however, that the size of the groups in the first and second sets need not be identical. For example, a bottom wafer/die may include n = 2 FETs per group in the associated first set of FET cells, and a top wafer/die may include n = 1 FET per group in the associated second set of FET cells. Since the groups in the sets of FET cells each comprise n FET cells, the left-most drain bus of each group of *n* FET cells can be considered a "first side" drain bus for the group, and the right-most source bus of each group of two FET cells can be considered a "second side" source bus for the group.

Although conventional FET cell pairs with "outer" edge source and drain buses may be used in the embodiments shown in FIGS. 9A-9B, improved FET cell pairs with "inside" source and drain buses spaced inwardly from the FET cell pair edges provide even greater planar area savings. For example, FIG. 10 is a stylized top view of the IC layout of a FET cell pair 914a from FIG. 9B, showing greater detail for the individual FET cells. The outer drain and source buses 514a, 514c for the example FET cell pair 914a (as well as for the other cell pairs 914b, 912a shown in FIG. 9B) may be spaced away from the "outer" edges of the cell pairs (indicated by dashed regions A and B) to, for example, the illustrated "inside" positions (bus 514b is a source/drain bus shared between the two FET cells that constitute the FET cell pair 914a). The effective width (across the figure) of the example FET cell pair 914a is thus decreased compared to a prior art 2-D FET cell pair (see, *e.g.,* the pair of FET cells 502a and 502b in FIG. 5). Since the conductive vias 906 and/or traces 908 (see FIG. 9A) provide flexibility in routing connections between top-wafer/die HBI plugs to bottom-wafer/die HBI plugs, and the outer drain and source buses 514a, 514b of the FET cell pair 914a need not couple to an adjacent cell pair in the same wafer/die, but instead may couple to associated FET cell pairs in the HBI connected wafer/die, "inside" placement of the drain and source buses 514a, 514b is a new design option that reduces the planar area of the FET cell 914a compared to a conventional 2-D FET cell pair.

### Third Embodiment, which does not form part of the claimed invention

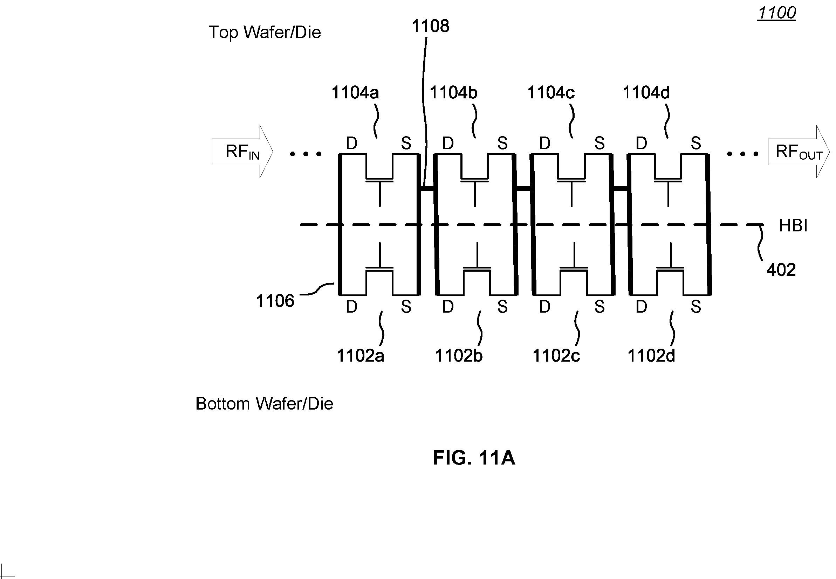

FIG. 11A is a schematic diagram of a third embodiment of a FET switch circuit 1100 configured to be implemented in a 3-D integrated circuit structure using HBI or analogous technology. In this example of the third embodiment, which does not form part of the claimed invention, a bottom wafer/die includes a first set of individual FET cells 1102a-1102d laid out in physical sequence, and the top wafer/die includes a second set of individual FET cells 1104a-1104d laid out in physical sequence. Thus, the first and second sets of FET cells each comprise one or more FET cells in groups of one. Within each wafer/die, the first set of FET cells 1102a-1102d and the second set of FET cells 1104a-1104d are each coupled in series. Conductive vias 1106 and/or traces 1108 are formed in known fashion in both the top and bottom wafers/dies to as to electrically connect, after application of an HBI bonding process, the FETs in the top and bottom wafers/dies in parallel (rather than the "zig-zag" connection configurations of the first and second embodiments described above). Thus, for example, the drain of a top-wafer/die FET cell *(e.g.,* FET cell 1104a) is coupled to the drain of an associated bottom-wafer/die FET cell *(e.g.,* FET cell 1102a), and the source of that bottom-wafer/die FET cell *(e.g.,* FET cell 1102a) is coupled to both the source of the same top-wafer/die FET cell *(e.g.,* FET cell 1104a) and to the drain of an associated next top-wafer/die FET cell *(e.g.,* FET cell 1104b). An RF_{IN} signal applied to the drains of FET cells 1104a and 1106a may be selectively conducted as an output signal through the sources of FET cells 1104d and 1106d, or blocked, based on applied gate control signals for the sets of FET cells 1102a-1102d, 1104a-1104d.

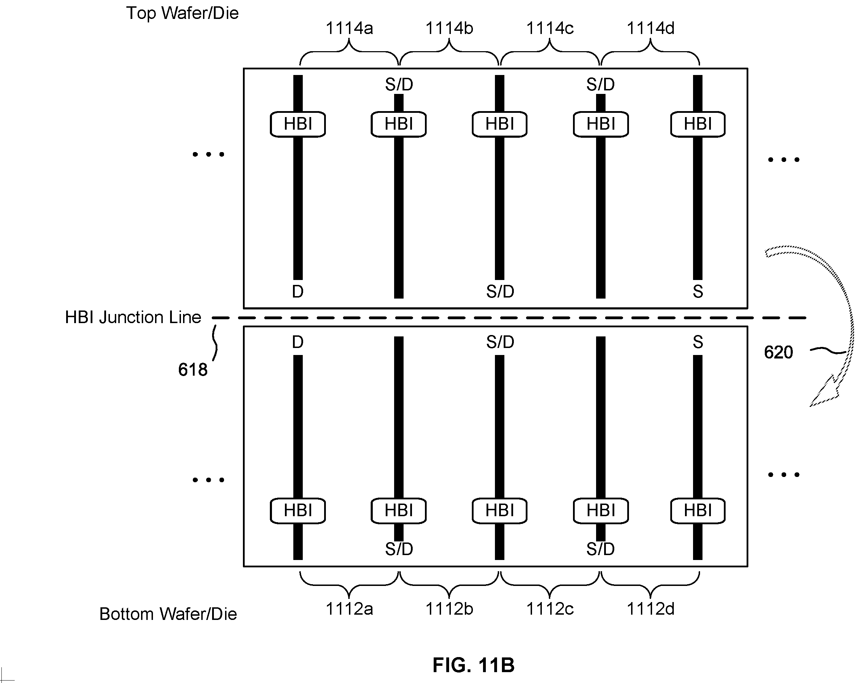

FIG. 11B is a stylized IC layout of the FET switch circuit 1100 of FIG. 11A, showing the pre-bonding positions of HBI plugs on top and bottom wafers/dies. A bottom wafer/die is shown as including a first set of 4 series-coupled FET cells 1112a-1112d, and a top wafer/die is shown as including a second set of 4 series-coupled FET cells 1114a-1114d (keeping in mind that some adjacent FET cells share source/drain buses S/D). The first and second sets of FET cells 1112a-1112d, 1114a-1114d are depicted in simplified form, but would be similar in general to the FET cells 502a-502d shown in FIG. 5, except as to wafer/die-to-wafer/die connections. In effect, in the illustrated example, the first set of FET cells 602a-602d is paired 1:1 in parallel with the second set of FET cells 604a-604d, without interleaving. However, in alternative embodiments, the FET cells in the top and bottom wafers/dies may be grouped in groups of two or more FET cells, with HBI connections only between corresponding drain and source buses of the groups. For example, in FIG. 11A, top wafer/die FET cells 1104a and 1104b may be a first group, and FET cells 1104c and 1104d may be a second group. Similarly, bottom wafer/die FET cells 1102a and 1102b may be a first group, and FET cells 1102c and 1102d may be a second group. HBI connections would couple the first side drain buses and the second side source buses of the first groups of the top and bottom wafers/dies with no intermediate connections, and would couple the first side drain buses and the second side source buses of the second groups of the top and bottom wafers/dies with no intermediate connections.

Although FIG. 11 shows only one HBI plug per drain bus or source bus, multiple HBI plugs may be used on corresponding drain or source buses to reduce resistance.

Advantages of the parallel architecture shown in FIGS. 11A-11B include planar area savings and higher current capacity (since the first and second sets of series-coupled FET cells are connected in parallel), and potentially a smaller number of HBI plugs compared with the first and second embodiments, which may result in further planar area savings.

### Fourth Embodiment, which does not form part of the claimed invention

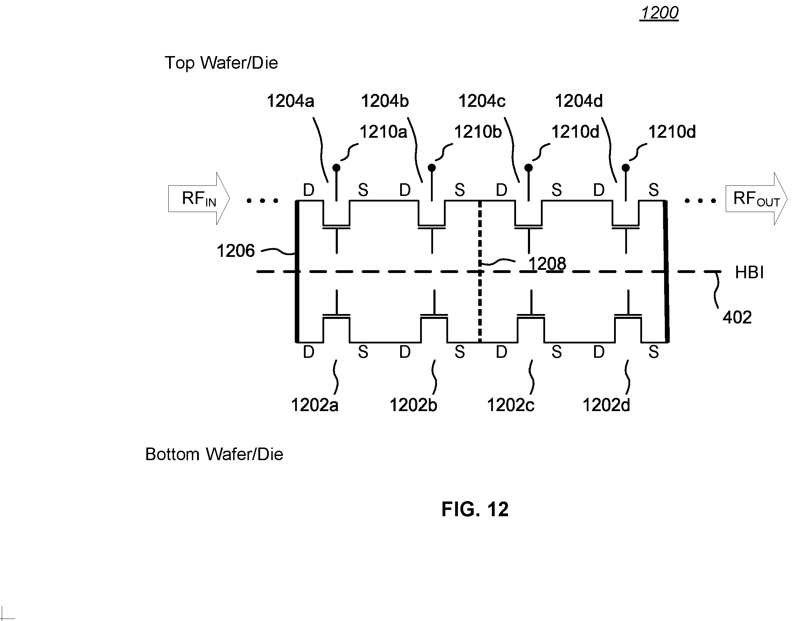

FIG. 12 is a schematic diagram of a fourth embodiment of a FET switch circuit 1200 configured to be implemented in a 3-D integrated circuit structure using HBI or analogous technology. In this example of the fourth embodiment, a bottom wafer/die includes a first set of individual FET cells 1202a-1202d laid out in physical sequence, and the top wafer/die includes a second set of individual FET cells 1204a-1204d laid out in physical sequence. Within each wafer/die, the first set of FET cells 1202a-1202d and the second set of FET cells 1204a-1204d are each coupled in series. Conductive vias 1206 and/or traces (not shown in this example) are formed in known fashion in both the top and bottom wafers/dies to as to electrically connect, after application of an HBI bonding process, the end FET cells in the top and bottom wafers/dies in parallel. Thus, for example, the drain of top-wafer/die FET cell 1204a is coupled to the drain of bottom-wafer/die FET cell 1202a, and the source of bottom-wafer/die FET cell 1202d is coupled to the source of top-wafer/die FET cell 1204d. An RF_{IN} signal applied to the drains of FET cells 1204a and 1202a may be selectively conducted as an output signal through the sources of FET cells 1204d and 1202d, or blocked, based on applied gate control signals for the sets of FET cells 1202a-1202d, 1204a-1204d.

Thus, while similar to the embodiment shown in FIG. 11A, the first and second sets of FET cells in the illustrated FET switch circuit 1200 of FIG. 12 are coupled only at their respective ends through first side drain buses and second side source buses. However, in alternative embodiments, intermediate connections may be used. For example, FIG. 12 shows an example of optional intermediate connection 1208. Of note, if the ends of the sets of FET cells are unconnected, the first and second sets of FET cells may be operated as two independent FET cell stacks.

### Back Biasing

It may be useful for some applications to back-bias the FET cells of the top wafer/die, particularly for an SOI top wafer/die. This may be accomplished by fabricating a conductive aligned supplemental (CAS) gate structure adjacent to "primary" FETs in the FET layer of the top wafer/die. In essence, this aspect of the invention takes advantage of the existence of an inherent secondary parasitic back-channel FET of some primary FETs (*e.g.,* an SOI FET) by fabricating such ICs using a process which allows access to the back side of the FET, such as the known Single Layer Transfer (SLT) process. Thereafter, a CAS gate structure is fabricated relative to a dielectric layer (*e.g.,* the BOX layer) juxtaposed to a primary FET such that a control voltage applied to the CAS gate can regulate the electrical characteristics of the regions of the primary FET. The CAS gate structure may be formed, for example, using redistribution layer (RDL) techniques.

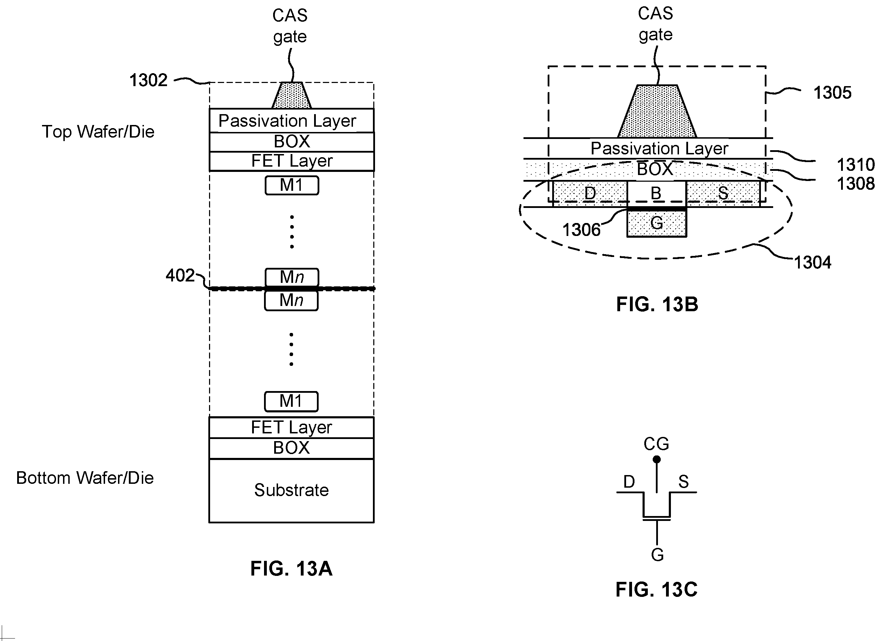

For example, FIG. 13A is a stylized cross-sectional view through a configuration 1302 of two SOI FETs bonded "top-to-top" using an HBI technology fabrication process. Similar in some respects to FIG. 4, in this example, the substrate layer of the top wafer/die has been removed in known fashion, temporarily exposing at least the portion of the BOX layer of the top wafer/die adjacent a primary FET. In this example, an optional passivation layer is then deposited over the exposed BOX layer areas, and a CAS gate is formed on the passivation layer adjacent the body of the primary FET. In other embodiments, a CAS gate may be formed directly on the BOX layer adjacent the body of the primary FET *(i.e.,* above the body relative to the figure).

FIG. 13B is a stylized cross-sectional detailed view of the FET layer and CAS gate structure of FIG. 13A, omitting the other structures shown in FIG. 13A for clarity. A primary FET (encompassed by dashed oval 1304) comprises a drain D, a source S, and a primary gate G atop an insulating gate oxide (GOX) layer 1306. A body B is defined by the primary gate G between the source S and the drain D (the primary FET is shown "upside down" in FIGS. 13A and 13B relative to conventional depictions because the top wafer/die is upside down relative to the bottom wafer/die).

With the presence of the added CAS gate, a secondary FET (shown in a dashed square 1305) comprises the drain D, the source S, the CAS gate dielectric material *(i.e.,* BOX layer 1308 and/or a passivation layer 1310) between the CAS gate and the body B of the primary FET 1304, and the CAS gate. A primary FET 1304 having an added CAS gate may be referred to as a "CAS-gated FET". Further details regarding the structure and methods of fabricating CAS-gated FETs may be found in U.S. Patent No. 10,580,903, issued March 3, 2020, entitled *"Semiconductor-On-Insulator Transistor with Improved Breakdown Characteristics",* assigned to the assignee of the present invention and hereby incorporated by reference.

The secondary FET is an independently controllable MOSFET regulated by applying control signals to the CAS gate. This is in contrast to the formerly inherently present but uncontrolled secondary parasitic back-channel FET of SOI FET embodiments. A CAS-gated FET thus generally presents as a five-terminal device: source S, drain D, primary gate G, CAS gate, and a body contact (often not shown in symbolic representations). Note that there may be circumstances in which a CAS gate may be beneficial, but the body contact may not be needed, and thus such an IC structure would present as a four-terminal device. FIG. 13C is symbolic representation of a CAS-gated FET. As shown, the CAS-gated FET symbol includes conventional drain D, source S, and gate G terminals, with the CAS gate terminal indicated as "CG".

The relative thickness of the dielectric GOX layer 1306 for the primary gate G is generally much thinner (typically on the order of 2 to 3 orders of magnitude thinner) than the dielectric *(i.e.,* BOX layer 1308 and/or a passivation layer 1310) for the CAS gate. Thus, the CAS gate generally will have a smaller impact on current and threshold voltage in the body B of the primary FET 1304 for a particular applied voltage level. However, by applying control voltages to a CAS gate (typically DC voltages), various effects can be induced in and around the body B of the corresponding primary FET 1304, depending on the type of transistor originally made in the SOI structure. For example, for a partially depleted SOI primary FET 1304, the primary gate G and the CAS gate are isolated by undepleted silicon in the body of the device. Hence, voltages applied to the CAS gate will mostly affect back-channel leakage current, meaning leakage current that cannot be controlled by the primary gate G. Such leakage currents can be large compared to the leakage currents of the main body B under the primary gate G, often because the primary FET is designed to ensure low leakage currents. For example, for RF and analog circuits, very low leakage is key to proper performance. Charged nodes or storage capacitors can be discharged by leakage currents, thereby forcing a recharge cycle that can induce spurious signals ("spurs") in analog circuits that can degrade RF and analog system performance.

For a so-called fully depleted SOI primary FET 1304, a voltage applied to the CAS gate will couple capacitively to the primary body B of the primary FET 1304, thereby inducing some threshold voltage shift in the primary FET. The impact of leakage current in a fully depleted FET will have the same effects as for a partially depleted FET.

Another benefit of FETs having a CAS gate is that multiple FET devices can be identically fabricated (*e*.*g*., same implant doping levels) but controlled by respective CAS control voltages to operate with different threshold voltages, V_{T}. For example, in some applications, it may be useful to have some FETs with a lower V_{T} while other FETs have a higher V_{T}. This can be achieved by biasing the CAS gates of such FETs with different voltage values, which leads to the otherwise identical FETs exhibiting different threshold voltages V_{T}.

CAS-gated FETs generally have a higher voltage handling capability *(i.e.,* a higher breakdown voltage V_{BD}) than conventional FETs (typically exceeding an added 1-2 VDC of voltage handling capability for an SOI NMOS CAS-gated FET) due to the ability to bias the CAS gate such that the body B is more depleted than can be accomplished by the primary gate G alone. In addition, CAS-gated FETs generally have a lower ON resistance, R_{ON}, than conventional FETs (typically exceeding about 15% lower for switch FETs and about 30% lower for regular FETs, for SOI NMOS CAS-gated FET) due to the ability to bias the CAS gate such that the body B is more enhanced than can be accomplished by the primary gate G alone, resulting in lower insertion loss as well as a higher current capacity without increasing heat generation. CAS-gated FETs may have lower leakage currents in subthreshold operating conditions due to the ability to bias the back-channel region of the body in a fully OFF condition. Notably, all of these benefits - particularly high breakdown voltage V_{BD}, low R_{ON}, and lower leakage currents - are available from the same CAS-gated FET under different operating conditions, just by varying the bias voltage applied to its CAS gate.

The advantageous characteristics of CAS-gated FETs are particularly useful for signal switching applications, and especially RF signal switching circuits and systems. For example, referring to FIG. 12, the symbols of the sequence of FET cells 1204a-1204d in the top wafer/die are each represented as a CAS-gated FET having a respective CAS gate terminal 1210a-1210d. Accordingly, the example FET switch circuit 1200 may beneficially use back-biasing of the CAS gate terminal 1210a-1210d to improve the V_{BD}, R_{ON}, and leakage current characteristics of the FET cells 1204a-1204d. The FET cells of the top wafer/die in the circuits shown an FIGS. 6A and 9A may similarly be implemented as CAS-gated FETs, and thus beneficially use CAS gate back-biasing to improve the V_{BD}, R_{ON}, and leakage current characteristics of the FET cells.

### Circuit Embodiments

Circuits and devices in accordance with the present invention may be used alone or in combination with other components, circuits, and devices. Embodiments of the present invention may be fabricated as integrated circuits (ICs), which may be encased in IC packages and/or in modules for ease of handling, manufacture, and/or improved performance. In particular, IC embodiments of this invention are often used in modules in which one or more of such ICs are combined with other circuit components or blocks *(e.g.,* filters, amplifiers, passive components, and possibly additional ICs) into one package. The ICs and/or modules are then typically combined with other components, often on a printed circuit board, to form part of an end product such as a cellular telephone, laptop computer, or electronic tablet, or to form a higher-level module which may be used in a wide variety of products, such as vehicles, test equipment, medical devices, *etc.* Through various configurations of modules and assemblies, such ICs typically enable a mode of communication, often wireless communication.

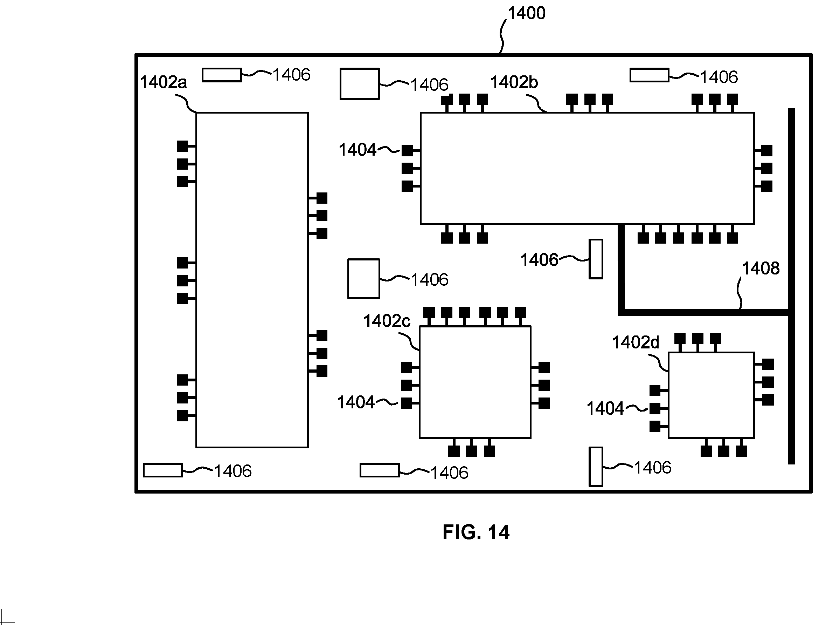

As one example of further integration of embodiments of the present invention with other components, FIG. 14 is a top plan view of a substrate 1400 that may be, for example, a printed circuit board or chip module substrate (*e*.*g*., a thin-film tile). In the illustrated example, the substrate 1400 includes multiple ICs 1402a-1402d having terminal pads 1404 which would be interconnected by conductive vias and/or traces on and/or within the substrate 1400 or on the opposite (back) surface of the substrate 1400 (to avoid clutter, the surface conductive traces are not shown and not all terminal pads are labelled). The ICs 1402a-1402d may embody, for example, signal switches, active filters, amplifiers (including one or more LNAs), and other circuitry. For example, IC 1402b may incorporate one or more instances of a FET switch circuit like the circuits shown in FIGS. 6A, 9A, 11A, and/or 12.

The substrate 1400 may also include one or more passive devices 1406 embedded in, formed on, and/or affixed to the substrate 1400. While shown as generic rectangles, the passive devices 1406 may be, for example, filters, capacitors, inductors, transmission lines, resistors, planar antennae elements, transducers (including, for example, MEMS-based transducers, such as accelerometers, gyroscopes, microphones, pressure sensors, *etc.),* batteries, *etc.,* interconnected by conductive traces on or in the substrate 1400 to other passive devices 1406 and/or the individual ICs 1402a-1402d.

The front or back surface of the substrate 1400 may be used as a location for the formation of other structures. For example, one or more antennae may be formed on or affixed to the front or back surface of the substrate 1400; one example of a front-surface antenna 1408 is shown, coupled to an IC die 1402b, which may include RF front-end circuitry. Thus, by including one or more antennae on the substrate 1400, a complete radio may be created.

### System Aspects

Embodiments of the present invention are useful in a wide variety of larger radio frequency (RF) circuits and systems for performing a range of functions, including (but not limited to) impedance matching circuits, RF power amplifiers, RF low-noise amplifiers (LNAs), phase shifters, attenuators, antenna beam-steering systems, charge pump devices, RF switches, *etc.* Such functions are useful in a variety of applications, such as radar systems (including phased array and automotive radar systems), radio systems (including cellular radio systems), and test equipment.

Radio system usage includes wireless RF systems (including base stations, relay stations, and hand-held transceivers) that use various technologies and protocols, including various types of orthogonal frequency-division multiplexing ("OFDM"), quadrature amplitude modulation ("QAM"), Code-Division Multiple Access ("CDMA"), Time-Division Multiple Access ("TDMA"), Wide Band Code Division Multiple Access ("W-CDMA"), Global System for Mobile Communications ("GSM"), Long Term Evolution ("LTE"), 5G, 6G, and WiFi (*e.g.,* 802.11a, b, g, ac, ax, be) protocols, as well as other radio communication standards and protocols.

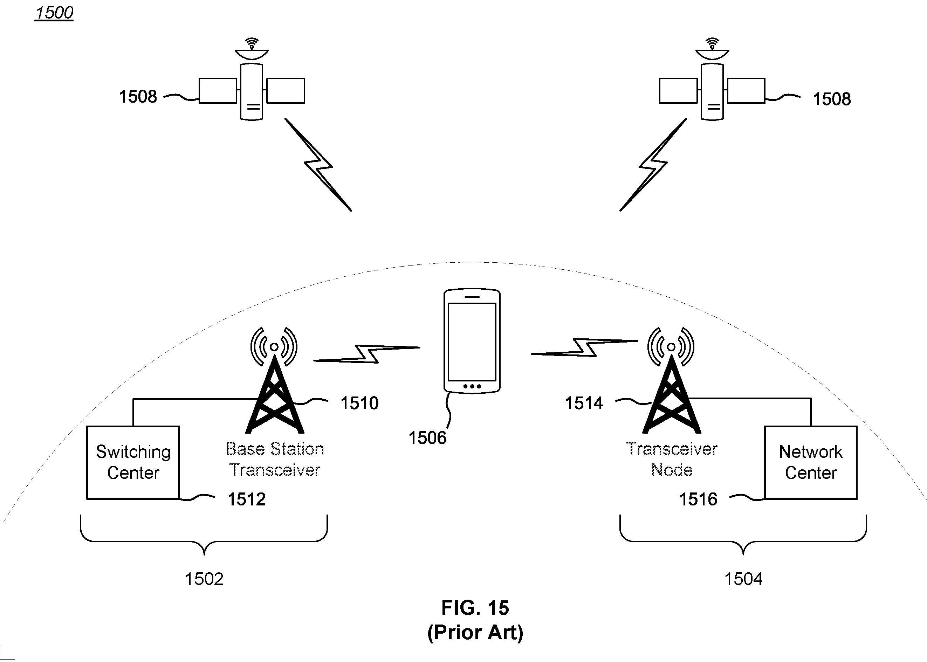

As an example of wireless RF system usage, FIG. 15 illustrates an exemplary prior art wireless communication environment 1500 comprising different wireless communication systems 1502 and 1504, and which may include one or more mobile wireless devices 1506. A wireless device 1506 may be a cellular phone, a wireless-enabled computer or tablet, or some other wireless communication unit or device. A wireless device 1506 may also be referred to as a mobile station, user equipment, an access terminal, or some other terminology known in the telecommunications industry.

A wireless device 1506 may be capable of communicating with multiple wireless communication systems 1502, 1504 using one or more of telecommunication protocols such as the protocols noted above. A wireless device 1506 also may be capable of communicating with one or more satellites 1508, such as navigation satellites (*e*.*g*., GPS) and/or telecommunication satellites. The wireless device 1506 may be equipped with multiple antennas, externally and/or internally, for operation on different frequencies and/or to provide diversity against deleterious path effects such as fading and multi-path interference.

The wireless communication system 1502 may be, for example, a CDMA-based system that includes one or more base station transceivers (BSTs) 1510 and at least one switching center (SC) 1512. Each BST 1510 provides over-the-air RF communication for wireless devices 1506 within its coverage area. The SC 1512 couples to one or more BSTs 1510 in the wireless system 1502 and provides coordination and control for those BSTs 1510.

The wireless communication system 1504 may be, for example, a TDMA-based system that includes one or more transceiver nodes 1514 and a network center (NC) 1516. Each transceiver node 1514 provides over-the-air RF communication for wireless devices 1506 within its coverage area. The NC 1516 couples to one or more transceiver nodes 1514 in the wireless system 1504 and provides coordination and control for those transceiver nodes 1514.

In general, each BST 1510 and transceiver node 1514 is a fixed station that provides communication coverage for wireless devices 1506, and may also be referred to as base stations or some other terminology known in the telecommunications industry. The SC 1512 and the NC 1516 are network entities that provide coordination and control for the base stations and may also be referred to by other terminologies known in the telecommunications industry.

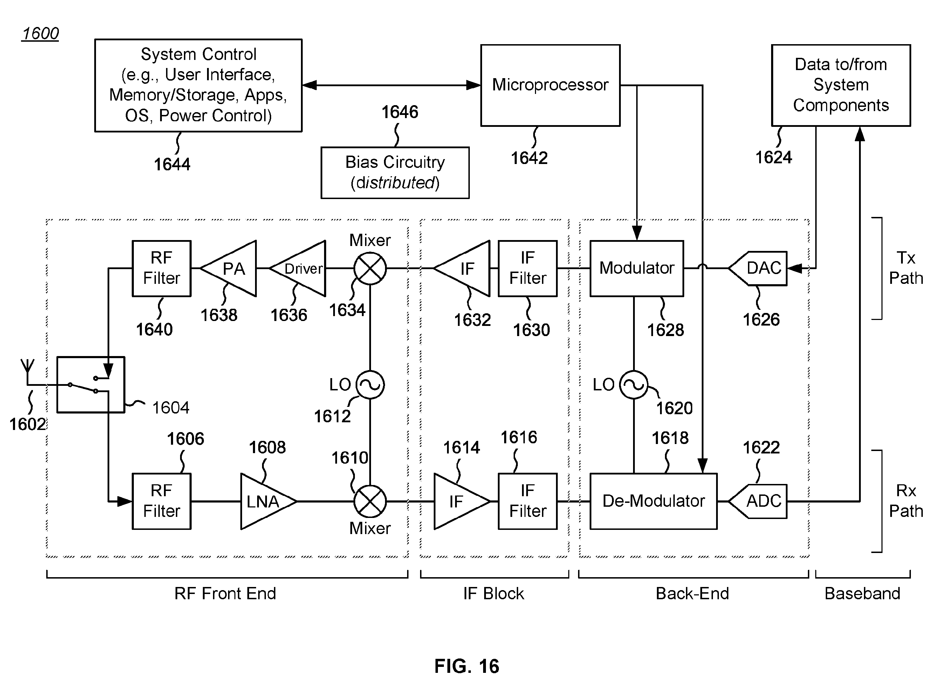

An important aspect of any wireless system, including the systems shown in FIG. 15, is in the details of how the component elements of the system perform. FIG. 16 is a block diagram of a transceiver 1600 that might be used in a wireless device, such as a cellular telephone, and which may beneficially incorporate an embodiment of the present invention. As illustrated, the transceiver 1600 includes a mix of RF analog circuitry for directly conveying and/or transforming signals on an RF signal path, non-RF analog circuity for operational needs outside of the RF signal path *(e.g.,* for bias voltages and switching signals), and digital circuitry for control and user interface requirements. In this example, a receiver path Rx includes RF Front End, Intermediate Frequency (IF) Block, Back-End, and Baseband sections (noting that in some implementations, the differentiation between sections may be different).

The receiver path Rx receives over-the-air RF signals through at least one antenna 1602 and a switching unit 1604, which may be implemented with active switching devices *(e.g.,* field effect transistors or FETs, including FET switch arrays of the types disclosed in FIGS. 6A, 9A, 11A, and/or 12) and/or with passive devices that implement frequency-domain multiplexing, such as a diplexer or duplexer. An RF filter 1606 passes desired received RF signals to at least one low noise amplifier (LNA) 1608, the output of which is combined in a corresponding mixer 1610 with the output of a first local oscillator 1612 to produce an IF signal. The IF signal may be amplified by an IF amplifier 1614 and subjected to an IF filter 1616 before being applied to a demodulator 1618, which may be coupled to a second local oscillator 1620. The demodulated output of the demodulator 1618 is transformed to a digital signal by an analog-to-digital converter 1622 and provided to one or more system components 1624 (*e.g.,* a video graphics circuit, a sound circuit, memory devices, *etc.).* The converted digital signal may represent, for example, video or still images, sounds, or symbols, such as text or other characters.

In the illustrated example, a transmitter path Tx includes Baseband, Back-End, IF Block, and RF Front End sections (again, in some implementations, the differentiation between sections may be different). Digital data from one or more system components 1624 is transformed to an analog signal by a digital-to-analog converter 1626, the output of which is applied to a modulator 1628, which also may be coupled to the second local oscillator 1620. The modulated output of the modulator 1628 may be subjected to an IF filter 1630 before being amplified by an IF amplifier 1632. The output of the IF amplifier 1632 is then combined in a mixer 1634 with the output of the first local oscillator 1612 to produce an RF signal. The RF signal may be amplified by a driver 1636, the output of which is applied to a power amplifier (PA) 1638. The amplified RF signal may be coupled to an RF filter 1640, the output of which is coupled to at least one antenna 1602 through the switching unit 1604.

The operation of the transceiver 1600 is controlled by a microprocessor 1642 in known fashion, which interacts with system control components 1644 *(e.g.,* user interfaces, memory/storage devices, application programs, operating system software, power control, *etc.).* In addition, the transceiver 1600 will generally include other circuitry, such as bias circuitry 1646 (which may be distributed throughout the transceiver 1600 in proximity to transistor devices), electro-static discharge (ESD) protection circuits, testing circuits (not shown), factory programming interfaces (not shown), *etc.*

In modern transceivers, there are often more than one receiver path Rx and transmitter path Tx, for example, to accommodate multiple frequencies and/or signaling modalities. Further, as should be apparent to one of ordinary skill in the art, some components of the transceiver 1600 may be positioned in a different order *(e.g.,* filters) or omitted. Other components can be (and often are) added, such as (by way of example only) additional filters, impedance matching networks, variable phase shifters/attenuators, power dividers, *etc.*

As discussed above, the current invention enables high performance FET switch arrays while consuming less planar area than conventional 2-D IC dies. As a person of ordinary skill in the art will understand, a system architecture is beneficially impacted by the current invention in critical ways, including enabling smaller sizes while maintaining important RF characteristics such as power efficiency, linearity, noise factor (NF), and impedance matching, without significant generation of unwanted harmonic frequencies.

### Methods

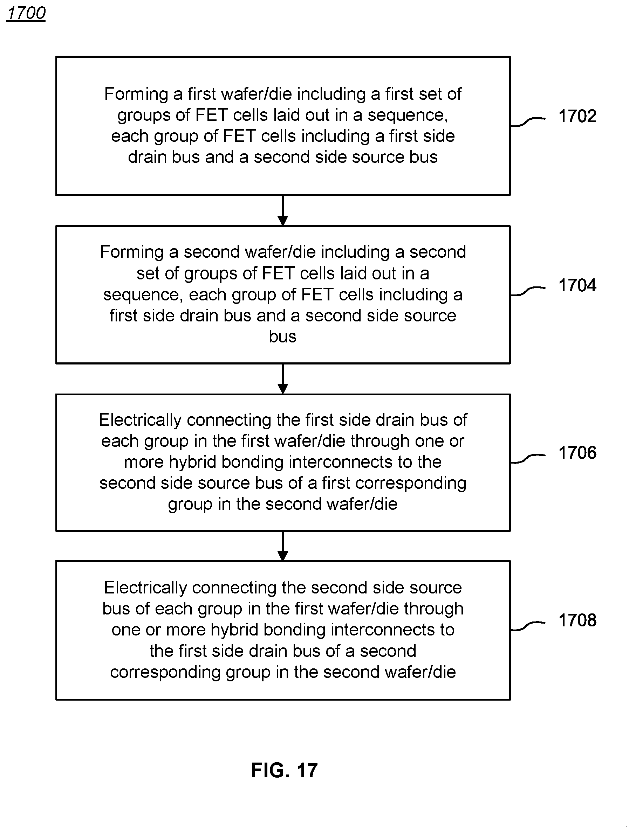

Another aspect of the invention includes a method for creating integrated FET switch circuits. FIG. 17 is a process flow chart 17 showing the method, which is according to the claimed invention, of creating an integrated FET switch circuit. The method includes: forming a first wafer/die including a first set of groups of FET cells laid out in a sequence, each group of FET cells including a first side drain bus and a second side source bus (Block 1702); forming a second wafer/die including a second set of groups of FET cells laid out in a sequence, each group of FET cells including a first side drain bus and a second side source bus (Block 1704); electrically connecting the first side drain bus of each group in the first wafer/die through one or more hybrid bonding interconnects to the second side source bus of a first corresponding group in the second wafer/die (Block 1706); and electrically connecting the second side source bus of each group in the first wafer/die through one or more hybrid bonding interconnects to the first side drain bus of a second corresponding group in the second wafer/die (Block 1708).

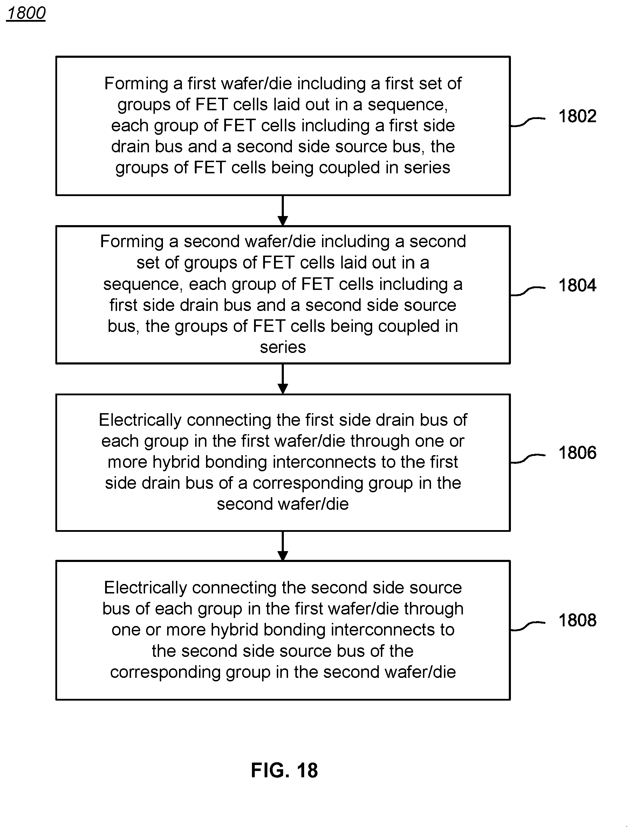

FIG. 18 is a process flow chart showing a second method of creating an integrated FET switch circuit. The second method, which does not form part of the claimed invention, includes: forming a first wafer/die including a first set of groups of FET cells laid out in a sequence, each group of FET cells including a first side drain bus and a second side source bus, the groups of FET cells being coupled in series (Block 1802); forming a second wafer/die including a second set of groups of FET cells laid out in a sequence, each group of FET cells including a first side drain bus and a second side source bus, the groups of FET cells being coupled in series (Block 1804); electrically connecting the first side drain bus of each group in the first wafer/die through one or more hybrid bonding interconnects to the first side drain bus of a corresponding group in the second wafer/die (Block 1806); and electrically connecting the second side source bus of each group in the first wafer/die through one or more hybrid bonding interconnects to the second side source bus of the corresponding group in the second wafer/die (Block 1808).

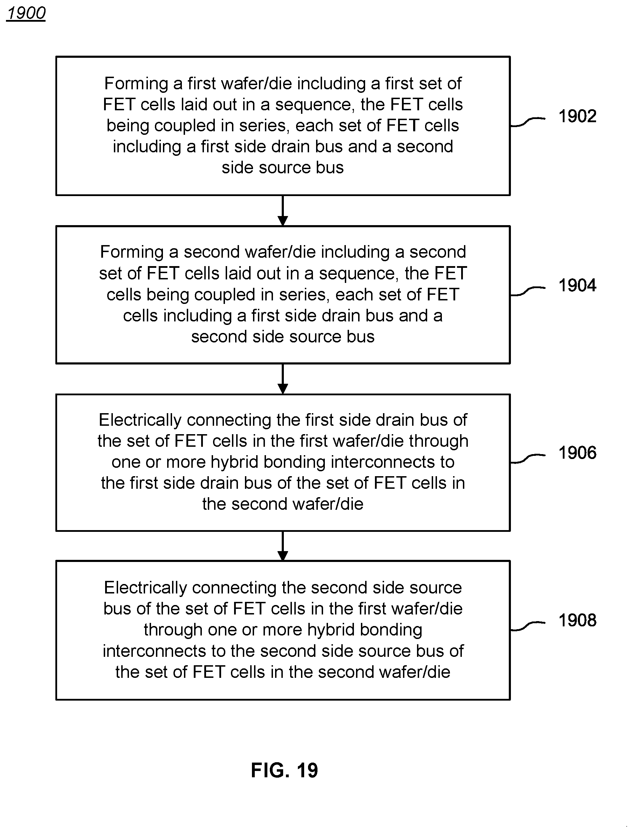

FIG. 19 is a process flow chart showing a third method of creating an integrated FET switch circuit. The third method, which does not form part of the claimed invention, includes: forming a first wafer/die including a first set of FET cells laid out in a sequence, the FET cells being coupled in series, each set of FET cells including a first side drain bus and a second side source bus (Block 1902); forming a second wafer/die including a second set of FET cells laid out in a sequence, the FET cells being coupled in series, each set of FET cells including a first side drain bus and a second side source bus (Block 1904); electrically connecting the first side drain bus of the set of FET cells in the first wafer/die through one or more hybrid bonding interconnects to the first side drain bus of the set of FET cells in the second wafer/die (Block 1906); and electrically connecting the second side source bus of the set of FET cells in the first wafer/die through one or more hybrid bonding interconnects to the second side source bus of the set of FET cells in the second wafer/die (Block 1908).

Additional aspects of the above methods may include one or more of the following:
wherein the integrated FET switch circuit is an integrated FET radio frequency switch circuit; wherein each group within the first set of groups and the second set of groups includes only one FET cell; wherein each group within the first set of groups and the second set of groups includes only two serially-coupled FET cells; wherein each group within the first set of groups and the second set of groups includes only *n* serially-coupled FET cells, where *n* ≥ 1; wherein the number of FET cells in the groups of the first set of groups is different from the number of FET cells in the groups of the second set of groups; wherein at least one FET cell in at least one of the first set of groups and/or the second set of groups includes a plurality of FETs coupled in parallel; wherein the FET cells of the second set of groups are CAS-gated FETs; wherein the FET cells of the second set of groups are back- biased; wherein the first side drain bus and the second side source bus of each group within the first set of groups and the second set of groups are spaced inside the edges of the group; and/or further including at least one intermediate hybrid bonding interconnect between the first set of FET cells and the second set of FET cells.

### Fabrication Technologies & Options

As the above examples should make clear, the invention applies to wafer-to-wafer HBI bonding, die-to-wafer HBI bonding, and die-to-die HBI bonding. Further, techniques analogous to HBI may also be used to bond top and bottom wafers/dies having the same architectures encompassed by the present invention. In addition, while several patterns of HBI connections have been shown, it should be appreciated that additional patterns may be used *(e.g.,* 3:3 interleaving, 4:4 interleaving, *etc.)* and that combinations of some of the patterns may be used *(e.g.,* 1:1 interleaving for a first part of a switch circuit and 2:2 interleaving for a second part of the switch circuit). Note also that metal interconnect layers with smaller dimensions (*e*.*g*., such as metal interconnect layers M1 and/or M2) may be used as routing layers to connect with smaller pitch HBI plugs. Thus, in general, a 3-D HBI stack of FET cells may be modified to add or remove metal layers based on HBI pitch and the intended application.

The substrates of the top and bottom wafers/dies may be of various types, including (in either order) SOI/SOI, SOI/bulk silicon bulk, silicon/bulk silicon, engineered substrate/bulk silicon, and engineered substrate/SOI. Engineered substrates include but are not limited to carbon-doped silicon, strained silicon, and porous silicon substrates, as well as other types having some modification of the constituent layers that compose the wafer/die through additional processing steps to make the wafer/die a better substrate for RF applications, such as by adding a trap rich layer right under the BOX layer of a SOI wafer/die to help improve RF performance.

The term "MOSFET", as used in this disclosure, includes any field effect transistor (FET) having an insulated gate whose voltage determines the conductivity of the transistor, and encompasses insulated gates having a metal or metal-like, and/or semiconductor structure. The terms "metal" or "metal-like" include at least one electrically conductive material (such as aluminum, copper, or other metal, or highly doped polysilicon, graphene, or other electrical conductor) and "semiconductor" includes at least one semiconductor material.

As used in this disclosure, the term "radio frequency" (RF) refers to a rate of oscillation in the range of about 3 kHz to about 300 GHz. This term also includes the frequencies used in wireless communication systems. An RF frequency may be the frequency of an electromagnetic wave or of an alternating voltage or current in a circuit.

With respect to the figures referenced in this disclosure, the dimensions for the various elements are not to scale; some dimensions may be greatly exaggerated vertically and/or horizontally for clarity or emphasis. In addition, references to orientations and directions (*e*.*g*., "top", "bottom", "above", "below", "lateral", "vertical", "horizontal", *etc.)* are relative to the example drawings, and not necessarily absolute orientations or directions.

Various embodiments of the invention can be implemented to meet a wide variety of specifications. Unless otherwise noted above, selection of suitable component values is a matter of design choice. Various embodiments of the invention may be implemented in any suitable integrated circuit (IC) technology (including but not limited to MOSFET structures), or in hybrid or discrete circuit forms. Integrated circuit embodiments may be fabricated using any suitable substrates and processes, including but not limited to standard bulk silicon, high-resistivity bulk CMOS, silicon-on-insulator (SOI), and silicon-on-sapphire (SOS). Unless otherwise noted above, embodiments of the invention may be implemented in other transistor technologies such as bipolar, BiCMOS, LDMOS, BCD, GaAs HBT, GaN HEMT, GaAs pHEMT, MESFET, SiGe, InP, ESOS (epitaxial SOS), BSOS (bonded SOS), and SOI-on-anything *(e.g.,* SOG = silicon-on-glass, SOC = silicon-on-ceramic, *etc.)* technologies. However, embodiments of the invention are particularly useful when fabricated using an SOI or SOS based process, or when fabricated with processes having similar characteristics. Fabrication in CMOS using SOI or SOS processes enables circuits with low power consumption, the ability to withstand high power signals during operation due to FET stacking, good linearity, and high frequency operation *(i.e.,* radio frequencies up to and exceeding 300 GHz). Monolithic IC implementation is particularly useful since parasitic capacitances generally can be kept low (or at a minimum, kept uniform across all units, permitting them to be compensated) by careful design.

Voltage levels may be adjusted, and/or voltage and/or logic signal polarities reversed, depending on a particular specification and/or implementing technology (*e*.*g*., NMOS, PMOS, or CMOS, and enhancement mode or depletion mode transistor devices). Component voltage, current, and power handling capabilities may be adapted as needed, for example, by adjusting device sizes, serially "stacking" components (particularly FETs) to withstand greater voltages, and/or using multiple components in parallel to handle greater currents. Additional circuit components may be added to enhance the capabilities of the disclosed circuits and/or to provide additional functionality without significantly altering the functionality of the disclosed circuits.

### Conclusion

A number of embodiments of the invention have been described. It is to be understood that various modifications may be made without departing from the scope of the invention, which is defined by the appended claims.

For example, some of the steps described above may be order independent, and thus can be performed in an order different from that described. Further, some of the steps described above may be optional. Various activities described with respect to the methods identified above can be executed in repetitive, serial, and/or parallel fashion.

It is to be understood that the foregoing description is intended to illustrate and not to limit the scope of the invention, which is defined by the scope of the following claims, and that other embodiments are within the scope of the claims. In particular, the scope of the invention includes any combination covered by the claims below.

## Claims

1. An integrated FET switch circuit (600, 900) including
(a) a first wafer/die including a first set of groups of FET cells (602a-602e ; 902a-902b) laid out in a sequence,
each group of FET cells including a first side drain bus (D) and a second side source bus (S);
and
(b) a second wafer/die joined to the first wafer/die through hybrid bonding interconnects (616, 916) and including a second set of groups of FET cells (604a-604f ; 904a-904c) laid out in a sequence, each group of FET cells including a first side drain bus (D) and a second side source bus (S),
wherein the first side drain bus of each group in the first wafer/die is electrically connected through the hybrid bonding interconnects to the second side source bus of a first corresponding group in the second wafer/die; and
wherein the second side source bus of each group in the first wafer/die is electrically connected through the hybrid bonding interconnects to the first side drain bus of a second corresponding group in the second wafer/die.

2. The invention of claim 1, wherein the integrated FET switch circuit is an integrated FET radio frequency switch circuit.

3. The invention of claim 1, wherein each group within the first set of groups and the second set of groups includes only one FET cell (602a-602e, 604a-604f).

4. The invention of claim 1, wherein each group within the first set of groups and the second set of groups includes only two serially-coupled FET cells (902a-902b, 904a-904c)

5. The invention of claim 1, wherein each group within the first set of groups and the second set of groups includes only *n* serially-coupled FET cells, where *n* ≥ 1.

6. The invention of claim 1, wherein the number of FET cells in the groups of the first set of groups is different from the number of FET cells in the groups of the second set of groups.

7. The invention of claim 1, wherein at least one FET cell in at least one of the first set of groups and/or the second set of groups includes a plurality of FETs coupled in parallel.

8. The invention of claim 1, wherein the FET cells of the second set of groups are CAS-gated FETs.

9. The invention of claim 1, wherein the FET cells of the second set of groups are back-biased.

10. The invention of claim 1, wherein the first side drain bus and the second side source bus of each group within the first set of groups and the second set of groups are spaced inside the edges of the group.

11. A method of creating an integrated FET switch circuit including:
(a) forming a first wafer/die including a first set of groups of FET cells laid out in a sequence, each group of FET cells including a first side drain bus and a second side source bus (1702);
(b) forming a second wafer/die including a second set of groups of FET cells laid out in a sequence, each group of FET cells including a first side drain bus and a second side source bus (1704);
(c) electrically connecting the first side drain bus of each group in the first wafer/die through one or more hybrid bonding interconnects to the second side source bus of a first corresponding group in the second wafer/die (1706); and
(d) electrically connecting the second side source bus of each group in the first wafer/die through one or more hybrid bonding interconnects to the first side drain bus of a second corresponding group in the second wafer/die (1708).

## Patentansprüche

1. Integrierter FET-Schaltkreis (600, 900), der Folgendes einschließt:
(a) einen ersten Wafer/Chip, der einen ersten Satz von Gruppen von FET-Zellen (602a-602e; 902a-902b) einschließt, die in einer Reihenfolge angeordnet sind, wobei jede Gruppe von FET-Zellen einen Drain-Bus (D) auf der ersten Seite und einen Source-Bus (S) auf der zweiten Seite einschließt; und
(b) einen zweiten Wafer/Chip, der mit dem ersten Wafer/Chip durch Hybridbond-Zwischenverbindungen (616, 916) verbunden ist und einen zweiten Satz von Gruppen von FET-Zellen (604a-604f; 904a-904c) einschließt, die in einer Reihenfolge angeordnet sind, wobei jede Gruppe von FET-Zellen einen Drain-Bus (D) auf der ersten Seite und einen Source-Bus (S) auf der zweiten Seite einschließt,
wobei der Drain-Bus auf der ersten Seite jeder Gruppe im ersten Wafer/Chip über die Hybridbond-Zwischenverbindungen elektrisch mit dem Source-Bus auf der zweiten Seite einer ersten entsprechenden Gruppe im zweiten Wafer/Chip verbunden ist; und wobei der Source-Bus auf der zweiten Seite jeder Gruppe im ersten Wafer/Chip über die Hybridbond-Zwischenverbindungen elektrisch mit dem Drain-Bus auf der ersten Seite einer zweiten entsprechenden Gruppe im zweiten Wafer/Chip verbunden ist.

2. Erfindung nach Anspruch 1, wobei der integrierte FET-Schaltkreis ein integrierter FET-Hochfrequenz-Schaltkreis ist.

3. Erfindung nach Anspruch 1, wobei jede Gruppe innerhalb des ersten Satzes von Gruppen und des zweiten Satzes von Gruppen nur eine FET-Zelle (602a-602e, 604a-604f) einschließt.

4. Erfindung nach Anspruch 1, wobei jede Gruppe innerhalb des ersten Satzes von Gruppen und des zweiten Satzes von Gruppen nur zwei seriell gekoppelte FET-Zellen (902a-902b, 904a-904c) einschließt.

5. Erfindung nach Anspruch 1, wobei jede Gruppe innerhalb des ersten Satzes von Gruppen und des zweiten Satzes von Gruppen nur n seriell gekoppelte FET-Zellen einschließt, wobei *n* ≥ l ist.

6. Erfindung nach Anspruch 1, wobei die Anzahl der FET-Zellen in den Gruppen des ersten Satzes von Gruppen von der Anzahl der FET-Zellen in den Gruppen des zweiten Satzes von Gruppen verschieden ist.

7. Erfindung nach Anspruch 1, wobei mindestens eine FET-Zelle in mindestens einem der ersten Sätze von Gruppen und/oder der zweiten Sätze von Gruppen eine Vielzahl von parallel geschalteten FETs einschließt.

8. Erfindung nach Anspruch 1, wobei die FET-Zellen des zweiten Satzes von Gruppen CAS-gesteuerte FETs sind.

9. Erfindung nach Anspruch 1, wobei die FET-Zellen des zweiten Satzes von Gruppen rückseitig vorgespannt sind.

10. Erfindung nach Anspruch 1, wobei der Drain-Bus auf der ersten Seite und der Source-Bus auf der zweiten Seite jeder Gruppe innerhalb des ersten Satzes von Gruppen und des zweiten Satzes von Gruppen innerhalb der Kanten der Gruppe beabstandet sind.

11. Verfahren zur Herstellung eines integrierten FET-Schaltkreises einschließlich:
(a) Bilden eines ersten Wafers/Chips, der einen ersten Satz von Gruppen von FET-Zellen einschließt, die in einer Reihenfolge angeordnet sind, wobei jede Gruppe von FET-Zellen einen Drain-Bus auf der ersten Seite und einen Source-Bus auf der zweiten Seite (1702) einschließt;
(b) Bilden eines zweiten Wafers/Chips, der einen zweiten Satz von Gruppen von FET-Zellen einschließt, die in einer Reihenfolge angeordnet sind, wobei jede Gruppe von FET-Zellen einen Drain-Bus auf der ersten Seite und einen Source-Bus auf der zweiten Seite (1704) einschließt;
(c) elektrisches Verbinden des Drain-Busses auf der ersten Seite jeder Gruppe im ersten Wafer/Chip durch eine oder mehrere Hybridbond-Zwischenverbindungen mit dem Source-Bus auf der zweiten Seite einer ersten entsprechenden Gruppe im zweiten Wafer/Chip (1706); und
(d) elektrisches Verbinden des Source-Busses auf der zweiten Seite jeder Gruppe in dem ersten Wafer/Chip durch eine oder mehrere Hybridbond-Zwischenverbindungen mit dem Drain-Bus auf der ersten Seite einer zweiten entsprechenden Gruppe in dem zweiten Wafer/Chip (1708).

## Revendications

1. Circuit de commutation FET intégré (600, 900) comprenant:
(a) une première tranche/matrice comprenant un premier ensemble de groupes de cellules FET (602a-602e ; 902a-902b) disposées en séquence, chaque groupe de cellules FET comprenant un bus de drain du premier côté (D) et un bus de source du second côté (S); et
(b) une seconde tranche/matrice reliée à la première tranche/matrice par des interconnexions de liaison hybride (616, 916) et comprenant un second ensemble de groupes de cellules FET (604a-604f; 904a-904c) disposées en séquence, chaque groupe de cellules FET comprenant un bus de drain du premier côté (D) et un bus de source du second côté (S),
dans lequel le bus de drain du premier côté de chaque groupe de la première tranche/matrice est connecté électriquement par les interconnexions de liaison hybride au bus de source du second côté d'un premier groupe correspondant de la seconde tranche/matrice; et
dans lequel le bus de source du second côté de chaque groupe de la première tranche/matrice est connecté électriquement par les interconnexions de liaison hybride au bus de drain du premier côté d'un second groupe correspondant de la seconde tranche/matrice.

2. Invention selon la revendication 1, dans laquelle le circuit de commutation FET intégré est un circuit de commutation radiofréquence FET intégré.

3. Invention selon la revendication 1, dans laquelle chaque groupe du premier ensemble de groupes et du second ensemble de groupes comprend une seule cellule FET (602a-602e, 604a-604f).

4. Invention selon la revendication 1, dans laquelle chaque groupe du premier ensemble de groupes et du second ensemble de groupes comprend seulement deux cellules FET couplées en série (902a-902b, 904a-904c).

5. Invention selon la revendication 1, dans laquelle chaque groupe du premier ensemble de groupes et du second ensemble de groupes comprend seulement n cellules FET couplées en série, où n ≥ l.

6. Invention selon la revendication 1, dans laquelle le nombre de cellules FET dans les groupes du premier ensemble de groupes est différent du nombre de cellules FET dans les groupes du second ensemble de groupes.

7. Invention selon la revendication 1, dans laquelle au moins une cellule FET dans au moins l'un du premier ensemble de groupes et/ou du second ensemble de groupes comprend une pluralité de FET couplés en parallèle.

8. Invention selon la revendication 1, dans laquelle les cellules FET du second ensemble de groupes sont des FET à sortie CAS.

9. Invention selon la revendication 1, dans laquelle les cellules FET du second ensemble de groupes sont polarisées en inverse.

10. Invention selon la revendication 1, dans laquelle le bus de drain du premier côté et le bus de source du second côté de chaque groupe dans le premier ensemble de groupes et le second ensemble de groupes sont espacés à l'intérieur des bords du groupe.

11. Procédé de création d'un circuit de commutation FET intégré consistant à:
(a) former une première tranche/matrice comprenant un premier ensemble de groupes de cellules FET disposées en séquence, chaque groupe de cellules FET comprenant un bus de drain du premier côté et un bus de source du second côté (1702);
(b) former une seconde tranche/matrice comprenant un second ensemble de groupes de cellules FET disposées en séquence, chaque groupe de cellules FET comprenant un bus de drain du premier côté et un bus de source du second côté (1704);
(c) connecter électriquement le bus de drain du premier côté de chaque groupe de la première plaquette/matrice au bus de source du second côté d'un premier groupe correspondant de la seconde plaquette/matrice (1706) par l'intermédiaire d'une ou de plusieurs interconnexions de liaison hybride; et
(d) connecter électriquement le bus de source du second côté de chaque groupe de la première plaquette/matrice à travers une ou plusieurs interconnexions de liaison hybride au bus de drain du premier côté d'un second groupe correspondant de la seconde plaquette/matrice (1708).
